# EUROPEAN PATENT APPLICATION

(11) **EP 4 769 943 A1**
(43) Date of publication of application: **01.07.2026**
(21) Application number: 24905421.4
(22) Date of filing: 21.05.2024
(51) Int. Cl.: H03F 1/56, H03F 3/19, H03G 3/30

(54) **MULTI-MODE INDUCTIVE CIRCUIT, CONTROL METHOD, LOW-NOISE AMPLIFIER, AND ELECTRONIC DEVICE**

(30) Priority: 22.12.2023 CN 202311774617
(71) Applicant: Honor Device Co., Ltd., Shenzhen, Guangdong 518040 (CN)
(72) Inventor: SUN, Jiangtao, Shenzhen, Guangdong 518040 (CN); HUANG, Qinghua, Shenzhen, Guangdong 518040 (CN); AN, Yang, Shenzhen, Guangdong 518040 (CN); MEI, Zheng, Shenzhen, Guangdong 518040 (CN)
(74) Representative: Henselmann, Alexander Gerhard
(86) International application number: PCT/CN2024/094559
(87) International publication number: WO 2025/129917

(57) **Abstract**

This application relates to the field of electronic device technologies, and discloses a multi-mode inductive circuit, a control method, a low noise amplifier, and an electronic device. The multi-mode inductive circuit includes an input node, at least two inductors, at least three switches, and an output node. The input node is electrically connected to a first terminal of one of the inductors. The input node is further electrically connected to a first terminal of the other inductor through a switch. A second terminal of the one inductor is electrically connected to the output node through an other switch. The second terminal of the one inductor is further electrically connected to the first terminal of the other inductor through the other switch. A second terminal of the other inductor is electrically connected to the output node. At least four inductance values of the multi-mode inductive circuit are determined through closing and opening of the at least three switches. Based on the solution of this application, inductance values for more modes may be obtained, thereby obtaining more gain modes for the low noise amplifier, and the circuit structure is simple.

## Description

This application claims priority to Chinese Patent Application No. 202311774617.4, filed with the China National Intellectual Property Administration on December 22, 2023 and entitled "MULTI-MODE INDUCTIVE CIRCUIT, CONTROL METHOD, LOW NOISE AMPLIFIER, AND ELECTRONIC DEVICE", which is incorporated herein by reference in its entirety.

### TECHNICAL FIELD

This application relates to the field of electronic device technologies, and in particular, to a multi-mode inductive circuit, a control method, a low noise amplifier, and an electronic device.

### BACKGROUND

In a radio frequency receive link to which wireless communication such as cellular, wireless fidelity (wireless fidelity, WIFI), or satellite communication is applied, a low noise amplifier is generally used to receive a specified downlink signal from various complex environments. In a process in which the low noise amplifier receives a downlink signal, a gain mode of the low noise amplifier is generally adjusted by changing an inductance value of an internal degeneration inductor.

Currently, the degeneration inductor in the low noise amplifier generally has only two inductance values. If more gain modes need to be implemented, a complex active circuit is needed to assist in implementation, resulting in increased circuit design complexity.

Therefore, a technical solution is urgently needed to resolve the foregoing problem.

### SUMMARY

This application provides a multi-mode inductive circuit, a control method, a low noise amplifier, and an electronic device. Inductance values of more types of degeneration inductors are added, so that more gain modes for the low noise amplifier can be obtained. In addition, the circuit structure is simple.

To achieve the foregoing objective, the following technical solutions are used in this application.

According to a first aspect, a multi-mode inductive circuit is provided, including an input node, at least two inductors, at least three switches, and an output node. The input node is electrically connected to a first terminal of one of the inductors. The input node is further electrically connected to a first terminal of the other inductor through a switch. A second terminal of the one inductor is electrically connected to the output node through an other switch. The second terminal of the one inductor is further electrically connected to the first terminal of the other inductor through the other switch. A second terminal of the other inductor is electrically connected to the output node. At least four inductance values of the multi-mode inductive circuit are determined through closing and opening of the at least three switches.

In embodiments of this application, an inductor having at least four inductance values may be obtained through connection of at least two inductors and at least three switches and closing and opening of the at least three switches, so that the low noise amplifier may obtain at least four gain modes. In addition, an entire circuit structure includes at least two inductors and at least three switches, and the circuit structure is simple.

With reference to the first aspect, in some implementations of the first aspect, the multi-mode inductive circuit includes an input node, a first inductor, a second inductor, a first switch, a second switch, a third switch, and an output node. The input node is electrically connected to a first terminal of the first inductor, the input node is further electrically connected to a first terminal of the second inductor through the first switch, a second terminal of the first inductor is electrically connected to the output node through the second switch, the second terminal of the first inductor is further electrically connected to the first terminal of the second inductor through the third switch, and a second terminal of the second inductor is electrically connected to the output node. At least four inductance values of the multi-mode inductive circuit are determined through closing and opening of the first switch, the second switch, and the third switch.

In embodiments of this application, a multi-mode inductive circuit may be obtained through two inductors and three switches. An inductor having four inductance values may be obtained through closing and opening of the three switches, so that the low noise amplifier can obtain at least four gain modes. In addition, an entire circuit structure includes only two inductors and three switches, and the circuit structure is simple.

With reference to the first aspect, in some implementations of the first aspect, the multi-mode inductive circuit further includes a fourth switch and a fifth switch. The first terminal of the second inductor is further electrically connected to the output node through the fourth switch, and the second terminal of the second inductor is further electrically connected to the output node through the fifth switch. At least five inductance values of the multi-mode inductive circuit are determined through closing and opening of the first switch, the second switch, the third switch, the fourth switch, and the fifth switch.

In embodiments of this application, another multi-mode inductive circuit may be obtained through two inductors and five switches. An inductor having five inductance values may be obtained through closing and opening of the five switches, so that the low noise amplifier can obtain at least five gain modes. In addition, the entire circuit structure includes only two inductors and five switches, and the circuit structure is simple.

According to a second aspect, a control method for a multi-mode inductive circuit is provided, including: obtaining closing signals and connection signals of three switches; and controlling on/off states of the three switches based on the closing signals and the connection signals of the three switches, to cause the multi-mode inductive circuit to obtain at least four inductance values.

In embodiments of this application, on/off states of the at least three switches may be controlled through the closing signals and connection signals of the at least three switches, so that the multi-mode inductive circuit can obtain at least four inductance values based on the on/off states of the at least three switches, and the low noise amplifier can obtain at least four gain modes.

With reference to the second aspect, in some implementations of the second aspect, the multi-mode inductive circuit includes an input node, a first inductor, a second inductor, a first switch, a second switch, a third switch, and an output node. The control method for the multi-mode inductive circuit includes: obtaining closing signals and connection signals of three switches; and controlling on/off states of the three switches based on the closing signals and the connection signals of the three switches, to cause the multi-mode inductive circuit to obtain at least four inductance values.

In embodiments of this application, on/off states of the three switches may be controlled through the closing signals and connection signals of the three switches, so that the multi-mode inductive circuit can obtain at least four inductance values based on on/off states of the three switches, and the low noise amplifier can obtain at least four gain modes.

With reference to the second aspect, in some implementations of the second aspect, the controlling on/off states of the three switches based on the closing signals and the connection signals of the three switches, to cause the multi-mode inductive circuit to obtain at least four inductance values includes: one of the inductance values of the multi-mode inductive circuit is the inductance value of the first inductor when the second switch is closed and the first switch and the third switch are opened.

In this implementation, the second switch is closed, and the first switch and the third switch are opened, so that an inductance value of an entire multi-mode inductive circuit can be the inductance value of the first inductor, thereby obtaining a gain mode of the low noise amplifier.

Optionally, when a coupling relationship exists between the first inductor and the second inductor, the inductance value of the mode inductive circuit is still the inductance value of the first inductor.

With reference to the second aspect, in some implementations of the second aspect, the controlling on/off states of the three switches based on the closing signals and the connection signals of the three switches, to cause the multi-mode inductive circuit to obtain at least four inductance values includes: one of the inductance values of the multi-mode inductive circuit is the inductance value of the second inductor when the first switch is closed and the second switch and the third switch are opened.

In this implementation, the first switch is closed, and the second switch and the third switch are opened, so that the inductance value of the entire multi-mode inductive circuit can be the inductance value of the second inductor, thereby obtaining another gain mode of the low noise amplifier.

Optionally, when the coupling relationship exists between the first inductor and the second inductor, the inductance value of the mode inductive circuit is still the inductance value of the second inductor.

With reference to the second aspect, in some implementations of the second aspect, the controlling on/off states of the three switches based on the closing signals and the connection signals of the three switches, to cause the multi-mode inductive circuit to obtain at least four inductance values includes: one of the inductance values of the multi-mode inductive circuit is a series inductance value of the first inductor and the second inductor when the third switch is closed and the first switch and the second switch are opened.

In this implementation, the third switch is closed and the first switch and the second switch are opened, so that the inductance value of the entire multi-mode inductive circuit can be the series inductance value of the first inductor and the second inductor, thereby obtaining another gain mode of the low noise amplifier.

With reference to the second aspect, in some implementations of the second aspect, the controlling on/off states of the three switches based on the closing signals and the connection signals of the three switches, to cause the multi-mode inductive circuit to obtain at least four inductance values includes: one of the inductance values of the multi-mode inductive circuit is a parallel inductance value of the first inductor and the second inductor when the first switch and the second switch are closed and the third switch is opened.

In this implementation, the first switch and the second switch are closed, and the third switch is opened, so that the inductance value of the entire multi-mode inductive circuit can be the parallel inductance value of the first inductor and the second inductor, thereby obtaining another gain mode of the low noise amplifier.

With reference to the second aspect, in some implementations of the second aspect, the controlling on/off states of the three switches based on the closing signals and the connection signals of the three switches, to cause the multi-mode inductive circuit to obtain at least four inductance values includes: one of the inductance values of the multi-mode inductive circuit is a sum of a series inductance value of the first inductor and the second inductor and a mutual inductance value of the first inductor and the second inductor when the coupling relationship exists between the first inductor and the second inductor, the third switch is closed, and the first switch and the second switch are opened.

In this embodiment of this application, the coupling relationship exists between the first inductor and the second inductor. The third switch is closed, and the first switch and the second switch are opened, so that the inductance value of the multi-mode inductive circuit can be the sum of the series inductance value of the first inductor and the second inductor and the mutual inductance value of the first inductor and the second inductor, thereby obtaining another gain mode of the low noise amplifier.

With reference to the second aspect, in some implementations of the second aspect, the controlling on/off states of the three switches based on the closing signals and the connection signals of the three switches, to cause the multi-mode inductive circuit to obtain at least four inductance values includes: one of the inductance values of the multi-mode inductive circuit is a sum of a parallel inductance value of the first inductor and the second inductor and a mutual inductance value of the first inductor and the second inductor when the coupling relationship exists between the first inductor and the second inductor, the first switch and the second switch are closed, and the third switch is opened.

In this embodiment of this application, the coupling relationship exists between the first inductor and the second inductor. The first switch and the second switch are closed, and the third switch is opened, the inductance value of the entire multi-mode inductive circuit can be the sum of the parallel inductance value of the first inductor and the second inductor and the mutual inductance value of the first inductor and the second inductor, thereby obtaining another gain mode of the low noise amplifier.

With reference to the second aspect, in some implementations of the second aspect, the multi-mode inductive circuit includes an input node, a first inductor, a second inductor, a first switch, a second switch, a third switch, a fourth switch, a fifth switch, and an output node. The control method for the multi-mode inductive circuit includes: obtaining closing signals and connection signals of five switches; and controlling on/off states of the five switches based on the closing signals and the connection signals of the five switches, to cause the multi-mode inductive circuit to obtain at least five inductance values.

In this embodiment of this application, the on/off states of the five switches may be controlled through the closing signal and the connection signals of the five switches, so that the multi-mode inductive circuit can obtain at least five inductance values based on the on/off states of the five switches, and the low noise amplifier can obtain at least five gain modes.

With reference to the second aspect, in some implementations of the second aspect, the controlling on/off states of the five switches based on the closing signals and the connection signals of the five switches, to cause the multi-mode inductive circuit to obtain at least five inductance values includes: one of the inductance values of the multi-mode inductive circuit is the inductance value of the first inductor when the second switch and the fifth switch are closed and the first switch, the third switch, and the fourth switch are opened.

In this implementation, the second switch and the fifth switch are closed, and the first switch, the third switch, and the fourth switch are opened, so that the inductance value of the entire multi-mode inductive circuit can be the inductance value of the first inductor, thereby obtaining another gain mode of the low noise amplifier.

Optionally, when a coupling relationship exists between the first inductor and the second inductor, the inductance value of the mode inductive circuit is still the inductance value of the first inductor.

With reference to the second aspect, in some implementations of the second aspect, the controlling on/off states of the five switches based on the closing signals and the connection signals of the five switches, to cause the multi-mode inductive circuit to obtain at least five inductance values includes: one of the inductance values of the multi-mode inductive circuit is the inductance value of the second inductor when the first switch and the fifth switch are closed and the second switch, the third switch, and the fourth switch are opened.

In this implementation, the first switch and the fifth switch are closed, and the second switch, the third switch, and the fourth switch are opened, so that the inductance value of the multi-mode inductive circuit can be the inductance value of the second inductor, thereby obtaining another gain mode of the low noise amplifier.

Optionally, when the coupling relationship exists between the first inductor and the second inductor, the inductance value of the mode inductive circuit is still the inductance value of the second inductor.

With reference to the second aspect, in some implementations of the second aspect, the controlling on/off states of the five switches based on the closing signals and the connection signals of the five switches, to cause the multi-mode inductive circuit to obtain at least five inductance values includes: one of the inductance values of the multi-mode inductive circuit is a series inductance value of the first inductor and the second inductor when the third switch and the fifth switch are closed and the first switch, the second switch, and the fourth switch are opened.

In this implementation, the third switch and the fifth switch are closed, and the first switch, the second switch, and the fourth switch are opened, so that the inductance value of the entire multi-mode inductive circuit may be the series inductance value of the first inductor and the second inductor, thereby obtaining another gain mode of the low noise amplifier.

With reference to the second aspect, in some implementations of the second aspect, the controlling on/off states of the five switches based on the closing signals and the connection signals of the five switches, to cause the multi-mode inductive circuit to obtain at least five inductance values includes: one of the inductance values of the multi-mode inductive circuit is a parallel inductance value of the first inductor and the second inductor when the first switch, the second switch, and the fifth switch are closed and the third switch and the fourth switch are opened.

In this implementation, the first switch, the second switch, and the fifth switch are closed, and the third switch and the fourth switch are opened, so that the inductance value of the entire multi-mode inductive circuit can be the parallel inductance value of the first inductor and the second inductor, thereby obtaining another gain mode of the low noise amplifier.

With reference to the second aspect, in some implementations of the second aspect, the controlling on/off states of the five switches based on the closing signals and the connection signals of the five switches, to cause the multi-mode inductive circuit to obtain at least five inductance values includes: one of the inductance values of the multi-mode inductive circuit is a series inductance value of the first inductor and the second inductor when the second switch and the fourth switch are closed and the first switch, the third switch, and the fifth switch are opened.

In this implementation, the second switch and the fourth switch are closed, and the first switch, the third switch, and the fifth switch are opened, so that the inductance value of the entire multi-mode inductive circuit can be the series inductance value of the first inductor and the second inductor, thereby obtaining another gain mode of the low noise amplifier.

With reference to the second aspect, in some implementations of the second aspect, the controlling on/off states of the five switches based on the closing signals and the connection signals of the five switches, to cause the multi-mode inductive circuit to obtain at least five inductance values includes: one of the inductance values of the multi-mode inductive circuit is a sum of a series inductance value of the first inductor and the second inductor and a mutual inductance value of the first inductor and the second inductor when the coupling relationship exists between the first inductor and the second inductor, the third switch and the fifth switch are closed, and the first switch, the second switch, and the fourth switch are opened.

In embodiments of this application, the coupling relationship exists between the first inductor and the second inductor. The third switch and the fifth switch are closed, and the first switch, the second switch, and the fourth switch are opened, so that the inductance value of the entire multi-mode inductive circuit is the sum of the series inductance value of the first inductor and the second inductor and the mutual inductance value of the first inductor and the second inductor, thereby obtaining another gain mode of the low noise amplifier.

With reference to the second aspect, in some implementations of the second aspect, the controlling on/off states of the five switches based on the closing signals and the connection signals of the five switches, to cause the multi-mode inductive circuit to obtain at least five inductance values includes: one of the inductance values of the multi-mode inductive circuit is a sum of a parallel inductance value of the first inductor and the second inductor and a mutual inductance value of the first inductor and the second inductor when the coupling relationship exists between the first inductor and the second inductor, the third switch and the fifth switch are closed, and the first switch, the second switch, and the fourth switch are opened.

In this implementation, the coupling relationship exists between the first inductor and the second inductor. The first switch, the second switch, and the fifth switch are closed, and the third switch and the fourth switch are opened, so that the inductance value of the entire multi-mode inductive circuit can be the sum of the parallel inductance value of the first inductor and the second inductor and the mutual inductance value of the first inductor and the second inductor, thereby obtaining another gain mode of the low noise amplifier.

With reference to the second aspect, in some implementations of the second aspect, the controlling on/off states of the five switches based on the closing signals and the connection signals of the five switches, to cause the multi-mode inductive circuit to obtain at least five inductance values includes: one of the inductance values of the multi-mode inductive circuit is a sum of a series inductance value of the first inductor and the second inductor and a mutual inductance value of the first inductor and the second inductor when the coupling relationship exists between the first inductor and the second inductor, the first switch, the second switch, and the fifth switch are closed, and the third switch and the fourth switch are opened.

In this implementation, the coupling relationship exists between the first inductor and the second inductor. The second switch and the fourth switch are closed, and the first switch, the third switch, and the fifth switch are opened, so that the inductance value of the entire multi-mode inductive circuit is the sum of the series inductance value of the first inductor and the second inductor and the mutual inductance value of the first inductor and the second inductor, thereby obtaining another gain mode of the low noise amplifier.

According to a third aspect, a low noise amplifier is provided, including the multi-mode inductive circuit.

In embodiments of this application, the multi-mode inductive circuit is integrated in the low noise amplifier. Through connection of at least two inductors and at least three switches and closing and opening of the at least three switches, at least four inductance values may be obtained, so that the low noise amplifier can obtain at least four gain modes. In addition, the entire circuit structure is simple.

With reference to the third aspect, in some implementations of the third aspect, the low noise amplifier further includes a power supply and a cascode amplifier obtained by cascading a common-source amplifier and a common-gate amplifier. A gate of the common-source amplifier is electrically connected to a signal input terminal, a source of the common-source amplifier is electrically connected to an input node of the multi-mode inductive circuit, a drain of the common-source amplifier is electrically connected to a source of the common-gate amplifier, a gate of the common-gate amplifier is grounded, and a drain of the common-gate amplifier is further electrically connected to a signal output terminal and the power supply.

In embodiments of this application, a load is used for a frequency selection on an output signal of the low noise amplifier, an input signal is amplified through the cascode amplifier, and an inductance value of a degeneration inductor of the cascode amplifier is adjusted through the multi-mode inductive circuit, so that the low noise amplifier can obtain at least four gain modes. In addition, the entire circuit structure is simple.

With reference to the third aspect, in some implementations of the third aspect, the low noise amplifier includes a plurality of cascode amplifiers, where gates of common-source amplifiers of the plurality of cascode amplifiers are all electrically connected to the signal input terminal, sources of the common-source amplifiers of the plurality of cascode amplifiers are all electrically connected to the input node of the multi-mode inductive circuit, and drains of common-gate amplifiers of the plurality of cascode amplifiers are all electrically connected to the signal output terminal.

In embodiments of this application, a magnitude of a current into the multi-mode inductive circuit is adjusted through one or more cascode amplifiers, so that the low noise amplifier can obtain at least four gain modes through any combination of the one or more cascode amplifiers and the multi-mode inductive circuit.

With reference to the third aspect, in some implementations of the third aspect, the low noise amplifier further includes a load. The load is connected between the power supply and the cascode amplifier. The load includes an adjustable resistor, an inductor, and an adjustable capacitor. One terminal of the adjustable resistor, one terminal of the inductor, and one terminal of the adjustable capacitor are all electrically connected to the power supply, and an other terminal of the adjustable resistor, an other terminal of the inductor, and an other terminal of the adjustable capacitor are all electrically connected to the signal output terminal.

In this embodiment of this application, a frequency-selective signal range for the load can be adjusted through a resistance value of the adjustable resistor, an inductance value of the inductor, and a capacitance value of the adjustable capacitor, causing the low noise amplifier to obtain more gain modes.

With reference to the third aspect, in some implementations of the third aspect, the low noise amplifier further includes an input switch and a matching inductor. A movable terminal of the input switch receives input signals of a plurality of bands, and a fixed terminal of the input switch is electrically connected to the signal input terminal through the matching inductor.

In the implementation, multi-band switching of an input signal may be achieved through the input switch, and multi-band noise or gain impedance matching of the input signal may be implemented through the matching inductor, so that the low noise amplifier can obtain more gain modes.

With reference to the third aspect, in some implementations of the third aspect, the low noise amplifier further includes one or more input inductors. The one or more input inductors are respectively electrically connected to the gates of one or more of the common-source amplifiers.

In the implementation, noise or gain impedance matching for specific bands may be implemented through one or more input inductors, so that the low noise amplifier can obtain more gain modes.

With reference to the third aspect, in some implementations of the third aspect, one or more common-source amplifiers are provided. One or more common-gate amplifiers are provided.

In the implementation, a quantity of the common-source amplifiers and a quantity of the common-gate amplifier may be adjusted based on an actual need, so that the low noise amplifier can obtain more gain modes.

According to a four aspect, a radio frequency front end module is provided, including a low noise amplifier.

According to a fifth aspect, a radio frequency front end chip is provided, including the foregoing radio frequency front end module.

According to a sixth aspect, an electronic device is provided, including the low noise amplifier.

In embodiments of this application, the electronic device receives a downlink signal through the low noise amplifier, and performs low noise amplification on the downlink signal, to obtain a received signal with a high signal-to-noise ratio.

### BRIEF DESCRIPTION OF DRAWINGS

FIG. 1 is a schematic diagram of a scenario of a mobile communication system to which an embodiment of this application is applied;
FIG. 2 is a schematic structural diagram of an electronic device according to an embodiment of this application;
FIG. 3 is a schematic structural diagram of a radio frequency front end module according to an embodiment of this application;
FIG. 4 is a circuit diagram of a degeneration inductor in a low noise amplifier according to an embodiment of this application;
FIG. 5 is a circuit diagram of a multi-mode inductive circuit according to another embodiment of this application;
FIG. 6 is a flowchart of a multi-mode inductive circuit according to an embodiment of this application;
FIG. 7 is a circuit diagram of a first mode of the multi-mode inductive circuit in FIG. 5;
FIG. 8 is a circuit diagram of a second mode of the multi-mode inductive circuit in FIG. 5;
FIG. 9 is a circuit diagram of a third mode of the multi-mode inductive circuit in FIG. 5;
FIG. 10 is a circuit diagram of a fourth mode of the multi-mode inductive circuit in FIG. 5;
FIG. 11 is a circuit diagram of a fifth mode of the multi-mode inductive circuit in FIG. 5;
FIG. 12 is a circuit diagram of a sixth mode of the multi-mode inductive circuit in FIG. 5;
FIG. 13 is a circuit diagram of a multi-mode inductive circuit according to another embodiment of this application;
FIG. 14 is a circuit diagram of a multi-mode inductive circuit according to another embodiment of this application;
FIG. 15 is a circuit diagram of a first mode of the multi-mode inductive circuit in FIG. 13;
FIG. 16 is a circuit diagram of a second mode of the multi-mode inductive circuit in FIG. 13;
FIG. 17 is a circuit diagram of a third mode of the multi-mode inductive circuit in FIG. 13;
FIG. 18 is a circuit diagram of a fourth mode of the multi-mode inductive circuit in FIG. 13;
FIG. 19 is a circuit diagram of a fifth mode of the multi-mode inductive circuit in FIG. 13;
FIG. 20 is a circuit diagram of a sixth mode of the multi-mode inductive circuit in FIG. 13;
FIG. 21 is a circuit diagram of a seventh mode of the multi-mode inductive circuit in FIG. 13;
FIG. 22 is a circuit diagram of an eighth mode of the multi-mode inductive circuit in FIG. 13;
FIG. 23 is a schematic structural diagram of a low noise amplifier according to an embodiment of this application;
FIG. 24 is a circuit diagram of a low noise amplifier according to an embodiment of this application;
FIG. 25 is circuit diagram of a low noise amplifier according to another embodiment of this application;
FIG. 26 is circuit diagram of a low noise amplifier according to another embodiment of this application;
FIG. 27 is circuit diagram of a low noise amplifier according to another embodiment of this application;
FIG. 28 is circuit diagram of a low noise amplifier according to another embodiment of this application;
FIG. 29 is circuit diagram of a low noise amplifier according to another embodiment of this application;
FIG. 30 is circuit diagram of a low noise amplifier according to another embodiment of this application;
FIG. 31 is circuit diagram of a low noise amplifier according to another embodiment of this application;
FIG. 32 is circuit diagram of a low noise amplifier according to another embodiment of this application;
FIG. 33 is circuit diagram of a low noise amplifier according to another embodiment of this application.

### DESCRIPTION OF EMBODIMENTS

The technical solutions in embodiments of this application are described clearly and in detail below with reference to the accompanying drawings. In the descriptions of embodiments of this application, unless otherwise specified, "/" means or. For example, A/B may represent A or B. In this specification, "and/or" only means an association relationship for describing associated objects, and represents that three relationships may exist. For example, A and/or B may represent the following three cases: only A exists, both A and B exist, and only B exists.

The terms "first", "second", and the like are merely intended for a purpose of description, and shall not be understood as an indication or implication of relative importance or implicit indication of the quantity of indicated technical features. Therefore, a feature defined to be "first" or "second" may explicitly or implicitly include one or more features. In the description of embodiments of this application, unless otherwise stated, "a plurality of" refers to two or more.

For ease of understanding embodiments of this application, terms and concepts related to embodiments of this application are first briefly described.

### 1. Radio frequency front end (radio frequency front end, RFFE)

In the field of communication, the radio frequency front end refers to a series of components between a radio frequency transceiver and an antenna, and mainly includes a power amplifier (PA), an antenna switch (Switch), a filter (Filter), a duplexer (Duplexer and Diplexer), and a low noise amplifier (LNA), which directly affects signal receiving and transmitting of an electronic device.

### 2. Low noise amplifier (low noise amplifier, LNA)

In the field of communication, the low noise amplifier refers to an amplifier with a very low noise figure, which is used as a high-frequency or intermediate-frequency preamplifier for various radio receivers and an amplification circuit for a high-sensitivity electronic detection device. In a scenario of amplifying a weak signal, noise of the amplifier may seriously interfere with the signal. In this case, it is expected to reduce the noise to improve an output signal-to-noise ratio.

### 3. Transmit (transmit, TX)

In the field of communication, transmitting refers to a behavior of sending data from a device to another device or a group of devices.

### 4. Receive (receive, RX)

In the field of communication, receiving refers to a process of converting a transmitted signal into perceivable information.

### 5. Noise matching

In the field of communication, the noise matching refers to a case that input impedance matching is changed to cause a current total noise figure to approach a minimum noise figure as much as possible. In an ideal noise matching situation, a current total noise figure of the input impedance matching is equal to a minimum noise figure. In addition, the noise impedance may also be changed through a change in a size of an electronic device.

### 6. Impedance matching

In the field of communication, the impedance matching refers to a suitable matching manner between a signal source or transmission line and a load. An internal resistance of a signal source is equal in magnitude and phase to a characteristic impedance of a connected transmission line, or a characteristic impedance of the transmission line is equal in magnitude and phase to an impedance of a connected load. It is respectively referred to that an input terminal or an output terminal of the transmission line is in an impedance matching state, which is referred to as the impedance matching for short. Otherwise, it is referred to as impedance mismatching.

### 7. Gain (gain)

In the field of communication, the gain generally refers to a ratio of a signal output of a system to a signal input. For example, an antenna gain represents a parameter of a concentration degree of directional antenna radiation, and is a ratio of squares of electric field strengths generated by a directional antenna and a non-directional antenna in a predetermined direction. An amplifier gain represents a power amplification multiple of the amplifier, and is represented by a common logarithm of a ratio of output power to input power.

### 8. Quality factor (quality factor, Q value)

In the field of communication, the quality factor indicates a quality indicator indicating a ratio of energy stored in an energy storage device (for example, an inductive coil or a capacitor) and a resonance circuit to energy lost per cycle. A Q value of a reactance element in a series resonance circuit is equal to a ratio of a reactance of the reactance element to an equivalent series resistance of the reactance element. A larger Q value of an element indicates better selectivity of a circuit or a network formed by the element.

### 9. Uplink signal

In the field of communication, the uplink signal refers to an uplink beam sent by an electronic device and received by a base station.

### 10. Downlink signal

In the field of communication, the downlink signal refers to a downlink beam sent by a base station and received by an electronic device.

### 11. Mutual inductance

In the field of circuits, the mutual inductance refers to a measure of induction between two circuits or induction between parts of the two circuits. When a current in one coil changes, an induced electromotive force is generated in another adjacent coil, which is referred to as a mutual inductance phenomenon. The mutual inductance phenomenon is a common electromagnetic inductance phenomenon that may occur not only between two coils wound on a same iron core, but also between any two circuits close to each other.

The above is a brief introduction to the terms involved in embodiments of this application. Details are not described below again.

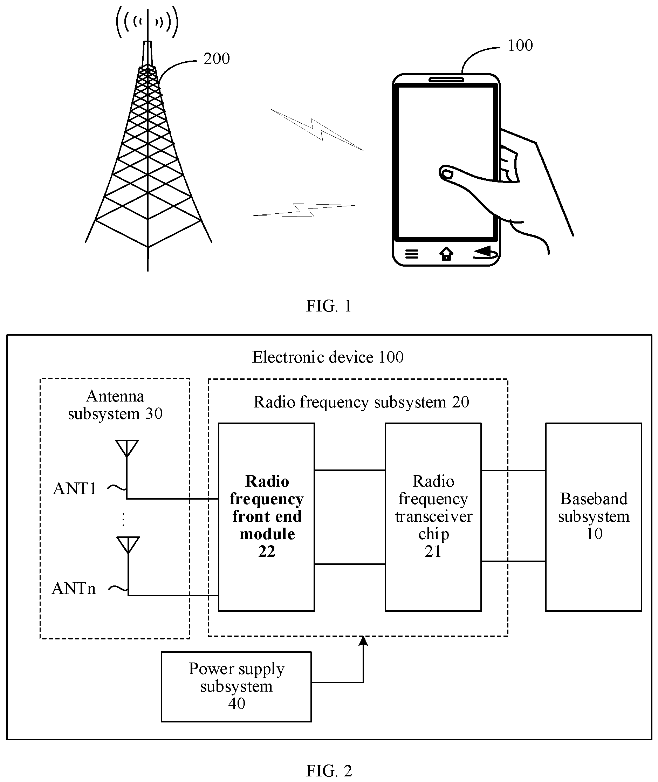

FIG. 1 is a schematic diagram of a scenario of a mobile communication system to which an embodiment of this application is applied.

As shown in FIG. 1, a user may communicate with a base station 200 through an electronic device 100. A type of the electronic device 100 is not specifically limited in this embodiment of this application. In some embodiments, the electronic device 100 may be a mobile phone, a wearable device (for example, a smart band, a smartwatch, or a headset), a tablet computer, a laptop computer (laptop), a handheld computer, a notebook computer, an ultra-mobile personal computer (ultra-mobile personal computer, UMPC), a cellular phone, a personal digital assistant (personal digital assistant, PDA), or an IOT (internet of things, IOT) device such as an augmented reality (augmented reality, AR)\virtual reality (virtual reality, VR) device, or may be a device such as a television, a big screen, a printer, or a projector. For ease of understanding, the following embodiments are exemplarily described by using an example in which the electronic device 100 is the mobile phone.

FIG. 2 is a schematic structural diagram of an electronic device according to an embodiment of this application.

As shown in FIG. 2, the electronic device 100 may include a baseband subsystem 10, a radio frequency subsystem 20 including a radio frequency transceiver chip (radio frequency integrated circuit, RFIC) 21 and a radio frequency front end module (radio frequency front end, RFFE) 22, an antenna (antenna, ANT) subsystem 30, a power supply subsystem 40, and the like. These devices may be coupled through various interconnection buses or in another electrical connection manner.

The baseband subsystem 10 may extract useful information or a data bit from a baseband signal, or convert information or a data bit into a to-be-sent baseband signal. The information or data bit may be data representing user data such as audio, a text, and a video, or control information. For example, the baseband subsystem 10 may implement signal processing operations such as modulation and demodulation, and encoding and decoding. For different radio access technologies, for example, 5G NR and 4G LTE, different baseband signal processing operations may be provided. Therefore, to support a plurality of mobile communication modes, the baseband subsystem 10 may simultaneously include a plurality of processing cores or a plurality of hardware accelerators (hardware accelerator, HAC). The baseband subsystem 10 may be integrated into one or more chips.

For example, the baseband subsystem 10 may be used as an independent chip, and the chip may be referred to as a modem (modem) chip. A hardware component of the baseband subsystem 10 may be manufactured and sold in a unit of the modem chip. The modem chip may alternatively be referred to as a baseband chip or a baseband processor. In addition, alternatively, the baseband subsystem 10 may be further integrated into a system on chip (system on chip technology, SOC) chip, and is manufactured and sold in a unit of the SOC chip. A software component of the baseband subsystem 10 may be built into a hardware component of a chip before the chip is delivered from a factory, or may be imported from another non-volatile memory into a hardware component of a chip after the chip is delivered from a factory, or may be downloaded and updated online through a network.

In addition, because a radio frequency signal is an analog signal, a signal processed by the baseband subsystem 10 is mainly a digital signal, and an analog-to-digital conversion device is further needed in the electronic device. The analog-to-digital conversion device may include an analog to digital converter (analog to digital converter, ADC) that converts an analog signal into a digital signal, and a digital to analog converter (digital to analog converter, DAC) that converts a digital signal into an analog signal. It should be understood that the analog-to-digital conversion device and the digital to analog converter may be arranged in the baseband subsystem 10, or may be arranged in the radio frequency subsystem 20. This is not limited in this embodiment of this application.

The radio frequency subsystem 20 may be divided into a radio frequency receiving path (RF receive path) and a radio frequency transmission path (TF transmit path). The radio frequency receiving path may receive a radio frequency signal through an antenna, perform processing such as amplification, filtering, down-conversion, and analog-to-digital conversion on the radio frequency signal to obtain a baseband signal, and transmit the baseband signal to the baseband subsystem 10. The radio frequency transmission path may receive a baseband signal from the baseband subsystem 10, perform processing such as up-conversion, amplification, filtering, and digital-to-analog conversion on the baseband signal to obtain a radio frequency signal, and radiate the radio frequency signal to space through an antenna. Specifically, the radio frequency subsystem 20 may include electronic devices such as a radio frequency switch, a duplexer, an antenna tuner, a low noise amplifier (low noise amplifier, LNA), a power amplifier, a mixer (mixer), a local oscillator (local oscillator, LO), and a filter. The electronic devices may be integrated into one or more chips based on a requirement. Sometimes, the antenna may alternatively be considered as a part of the radio frequency subsystem 20.

For example, the foregoing electronic devices may be separately arranged in the antenna, the radio frequency front end module 22, and the radio frequency transceiver chip 21. The radio frequency transceiver chip 21 may be formed by devices such as the mixer and the local oscillator. The local oscillator is configured to provide a local oscillator signal. The mixer is configured to perform frequency mixing on the radio frequency signal and the local oscillator signal provided by the local oscillator. The radio frequency transceiver chip 21 may alternatively be referred to as a receiver, a transmitter, a transceiver, or the like.

The radio frequency front end module 22 may be formed by electronic devices such as the filter, the low noise amplifier, the power amplifier, and the radio frequency switch. The radio frequency switch is configured to implement switching between reception and transmission of a radio frequency signal, and switching between different bands. The duplexer is configured to isolate a transmission path and a receiving path of a radio frequency signal, thereby ensuring normal operation of receiving and transmitting when sharing a same antenna. The filter is configured to reserve a signal in a particular band and filter out a signal outside a characteristic band. The low noise amplifier is configured to amplify the radio frequency signal of a receiving channel. The power amplifier is configured to amplify the radio frequency signal of the transmission path.

In this embodiment of this application, the low noise amplifier may include a multi-mode inductive circuit.

The radio frequency transceiver chip 21 herein may output a control signal to a component such as the radio frequency switch in the radio frequency front end module 22 through a control line, to control the radio frequency switch to switch between different links.

It should be understood that the foregoing is merely an example, and the radio frequency subsystem 20 may alternatively include another device or use another integrated manner. For example, a part of devices of the radio frequency front end module 22 may be integrated into the radio frequency transceiver chip 21, or both the antenna and the radio frequency front end module 22 are integrated into the radio frequency transceiver chip 21, which may be specifically arranged and modified based on a requirement. This is not limited in this embodiment of this application.

The antenna subsystem 30 includes a plurality of antennas. ANT1 represents a first antenna, and ANTn represents an n^{th} antenna, n being a positive integer greater than 1. The antenna subsystem 30 may also include an antenna switch configured to switch to a different antenna, so that different signals are transmitted through different antennas.

The power supply subsystem 40 is configured to supply power to each device. For example, the power supply may provide a voltage for the power amplifier. The power supply subsystem 40 may include a plurality of power supplies. The plurality of power supplies may be the same or may be different. The power supply subsystem 40 may further supply power to the baseband subsystem 10, the radio frequency subsystem 20, and the antenna subsystem 30. Power may be supplied to the subsystems through a same power supply or different power supplies.

In addition, the electronic device 100 may further include an application subsystem. The application subsystem may be used as a main control system or a main computing system of the electronic device 100, which is used to run a main operating system and an application, and manage software and hardware resources of the entire electronic device 100, and may provide a user operation interface for the user. The application subsystem may include one or more processing cores. In addition, the application subsystem may alternatively include drive software related to another subsystem (for example, the baseband subsystem 10). The baseband subsystem 10 may alternatively include one or more processing cores, a hardware accelerator, a cache, and the like.

It should be understood that the foregoing is merely an example for a structure of the electronic device 100, and the electronic device 100 may alternatively include another subsystem or device, which may be specifically arranged and modified based on a requirement. This is not limited in this embodiment of this application.

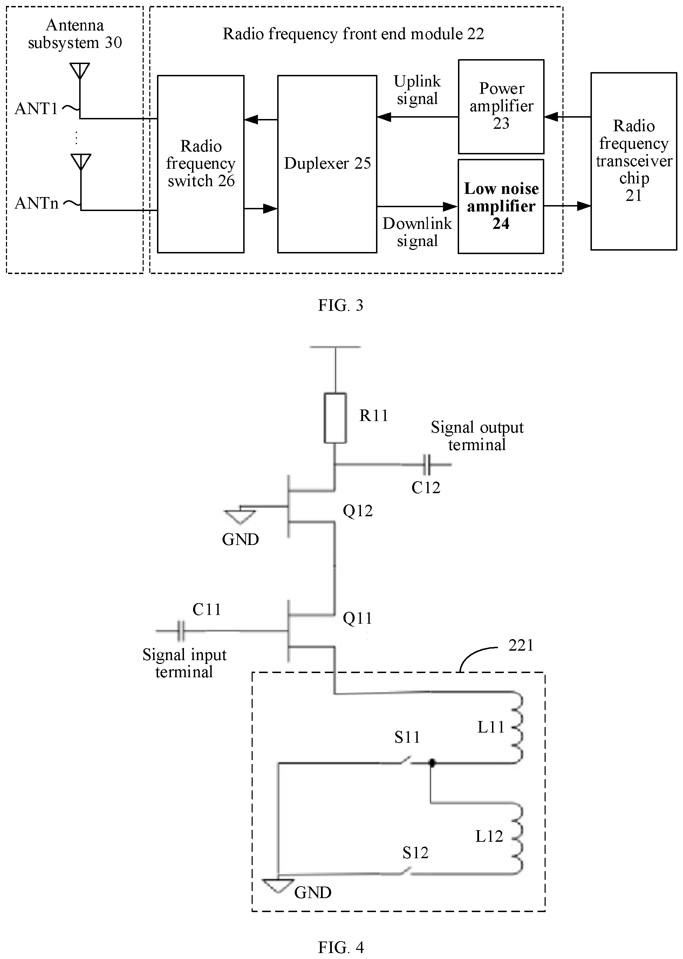

FIG. 3 is a schematic structural diagram of a radio frequency front end module according to an embodiment of this application.

As shown in FIG. 3, a radio frequency front end module 22 may include a power amplifier 23, a low noise amplifier 24, a duplexer 25, and a radio frequency switch 26. An input terminal of the power amplifier 23 is electrically connected to an output terminal of a radio frequency transceiver chip 21. An output terminal of the power amplifier 23 is electrically connected to the radio frequency switch 26 through the duplexer 25. The radio frequency switch 26 is further electrically connected to an input terminal of the low noise amplifier 24 through the duplexer 25. An output terminal of the low noise amplifier 24 is electrically connected to the radio frequency transceiver chip 21. An uplink signal flows through the power amplifier 23, and a downlink signal flows through the low noise amplifier 24.

The power amplifier 23 is configured to amplify a radio frequency signal of a transmission path. The low noise amplifier 24 is configured to amplify a radio frequency signal of a receiving path, and the duplexer 25 is configured to isolate the transmission path and the receiving path of the radio frequency signal, to ensure normal operation of receiving and transmitting when sharing a same antenna. The radio frequency switch 26 is configured to implement switching between receiving and transmitting the radio frequency signal and switching between different bands.

Currently, when the low noise amplifier in the radio frequency front end module 22 receives the downlink signal from a complex environment, input noise matching and input impedance matching of the low noise amplifier are usually adjusted through an internal degeneration inductor, thereby affecting an operating band and a multi-gain mode of the low noise amplifier. However, a degeneration inductor in an existing low noise amplifier generally has only two inductance values. Therefore, the low noise amplifier has only two gain modes, and fewer gain modes exist. When the low noise amplifier needs more gain modes, a manner of adding an auxiliary active circuit may also be used, but the circuit structure is complex.

In view of the above, embodiments of this application provide a multi-mode inductive circuit. Through connection of at least two inductors and at least three switches, and closing and opening of the at least three switches, an inductor having at least four inductance values may be obtained, so that the low noise amplifier may obtain at least four gain modes. In addition, an entire circuit structure includes at least two inductors and at least three switches, and the circuit structure is simple.

With reference to FIG. 4, detailed descriptions are first made on a problem that a degeneration inductor in a low noise amplifier has only two inductance values and the low noise amplifier has only two gain modes.

FIG. 4 is a circuit diagram of a degeneration inductor in a low noise amplifier according to an embodiment of this application.

As shown in FIG. 4, in an embodiment provided in this application, the low noise amplifier includes a degeneration inductor 221, a common-source amplifier Q11, a common-gate amplifier Q12, and an eleventh resistor R11. A source of the common-source amplifier Q11 is electrically connected to the degeneration inductor 221. A gate of the common-source amplifier Q11 is electrically connected to a signal input terminal through an eleventh capacitor C11. A drain of the common-source amplifier Q11 is electrically connected to a source of the common-gate amplifier Q12. A gate of the common-gate amplifier Q12 is grounded. The source of the common-gate amplifier Q12 is electrically connected to a signal output terminal through a twelfth capacitor C12. The source of the common-gate amplifier Q12 is further electrically connected to a power supply through the eleventh resistor R11.

In this embodiment of this application, the common-source amplifier Q11 and the common-gate amplifier Q12 are configured to amplify an input signal. The degeneration inductor 221 is configured to adjust an inductance value of the source of the common-source amplifier Q11. The eleventh resistor R11 is configured to perform frequency selection on an output signal. The eleventh capacitor C11 is configured to filter the input signal. The twelfth capacitor C12 is configured to filter the output signal.

As shown in FIG. 4, in an embodiment provided in this application, the degeneration inductor 221 includes an eleventh inductor L11, a twelfth inductor L12, an eleventh switch S11, and a twelfth switch S12. One terminal of the eleventh inductor L11 is electrically connected to the source of the common-source amplifier Q11. An other terminal of the eleventh inductor L11 is grounded through the eleventh switch S11. An other terminal of the eleventh inductor L11 is further grounded through the twelfth inductor L12 and the twelfth switch S12 in sequence.

In this embodiment of this application, through closing and opening of the eleventh switch S11 and the twelfth switch S12, inductance values of degeneration inductors in two modes are implemented, so that only two gain modes for the low noise amplifier can be implemented. For example, when the eleventh switch S11 is closed and the twelfth switch S12 is opened, an inductance value of the degeneration inductor 221 is an inductance value of the eleventh inductor L11. When the eleventh switch S11 is opened and the twelfth switch S12 is closed, the inductance value of the degeneration inductor 221 is a sum of an inductance value of the eleventh inductor L11 and an inductance value of the twelfth inductor L12. Therefore, when a terminal transceiver needs a gain mode with more levels, an inductance value mode of an existing degeneration inductor cannot satisfy a requirement.

Therefore, to resolve the problem that the degeneration inductor has fewer inductance value modes and cannot satisfy more inductance value modes in embodiments of this application, this application provides a multi-mode inductive circuit. Through connection of at least two inductors and at least three switches, and closing and opening of the at least three switches, an inductor having at least four inductance values may be obtained, so that the low noise amplifier can obtain at least four gain modes.

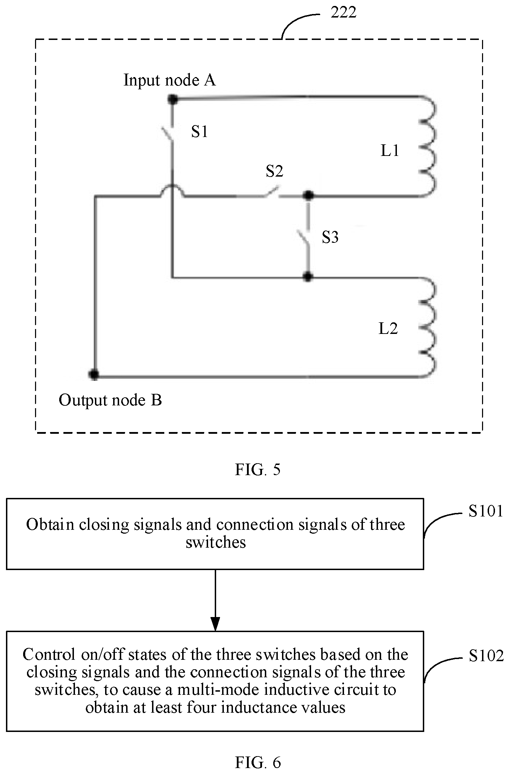

With reference to FIG. 5 to FIG. 22, a scheme in which a multi-mode inductive circuit having at least four inductance values is obtained through at least two inductors and at least three switches is described below.

In embodiments of this application, at least two inductors and at least three switches may be used. An input node is electrically connected to a first terminal of one inductor. The input node is further electrically connected to a first terminal of the other inductor through one switch. A second terminal of the inductor is electrically connected to an output node through the other switch. The second terminal of the inductor is further electrically connected to a first terminal of the another inductor through an other switch. A second terminal of the other inductor is electrically connected to an output node.

In an embodiment of this application, a control method for a multi-mode inductive circuit is further disclosed. Through closing and opening of at least three switches, on/off states of at least three switches are determined and controlled, to cause the multi-mode inductive circuit to obtain at least four inductance values, thereby causing the low noise amplifier to obtain at least four gain modes.

FIG. 5 is a circuit diagram of a multi-mode inductive circuit according to another embodiment of this application.

As shown in FIG. 5, a multi-mode inductive circuit 222 includes a first inductor L1, a second inductor L2, a first switch S1, a second switch S2, and a third switch S3. An input node A is electrically connected to a first terminal of the first inductor L1. The input node A is further electrically connected to a first terminal of the second inductor L2 through the first switch S1. A second terminal of the first inductor L1 is electrically connected to an output node B through the second switch S2. The second terminal of the first inductor L1 is further electrically connected to the first terminal of the second inductor L2 through the third switch S3. The second terminal of the second inductor L2 is electrically connected to the output node B. In addition, the input node A is further electrically connected to a source of a common-source amplifier. At least four inductance values of the multi-mode inductive circuit 222 are determined through closing and opening of the first switch S1, the second switch S2, and the third switch S3.

In this embodiment of this application, the multi-mode inductive circuit may be obtained through two inductors, that is, the first inductor L1 and the second inductor L2, and three switches, that is, the first switch S1, the second switch S2, and the third switch S3, so that an inductor having at least four inductance values can be obtained through closing and opening of the three switches, thereby causing the low noise amplifier to obtain at least four gain modes. In an actual application process, switching among at least four gain modes may be implemented based on an actual situation.

FIG. 6 is a flowchart of a multi-mode inductive circuit according to an embodiment of this application.

As shown in FIG. 6, this embodiment of this application further discloses a control method a multi-mode inductive circuit, including the following steps.

S101: Obtain closing signals and connection signals of three switches, that is, obtain closing signals and connection signals of a first switch S1, a second switch S2, and a third switch S3 manually or externally.

S102: Control on/off states of the three switches based on the closing signals and the connection signals of the three switches, to cause the multi-mode inductive circuit to obtain at least four inductance values. In other words, on/off states of the first switch S1, the second switch S2, and the third switch S3 are controlled based on the closing signals and the connection signals of the first switch S1, the second switch S2, and the third switch S3, so that the multi-mode inductive circuit 222 forms different inductance paths and obtains different inductance values, thereby causing the low noise amplifier to obtain more gain modes.

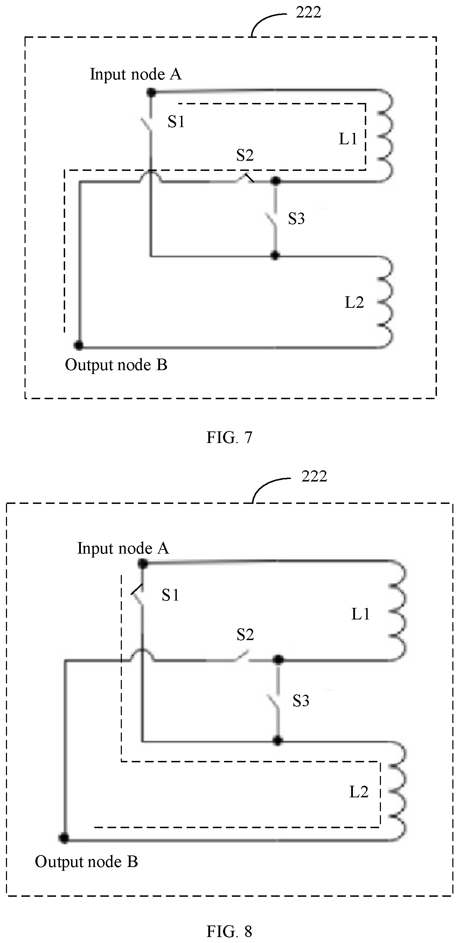

FIG. 7 is a circuit diagram of a first mode of the multi-mode inductive circuit in FIG. 5.

As shown in FIG. 7, in another embodiment provided in this application, when the second switch S2 is closed, and the first switch S1 and the third switch S3 are opened, the first inductor L1 independently operates as a degeneration inductor, and the second inductor L2 does not operate. Therefore, an inductance value of the multi-mode inductive circuit 222 is an inductance value of the first inductor L1, that is, L1. For example, when a coupling relationship exists between the first inductor L1 and the second inductor L2, the inductance value of the multi-mode inductive circuit 222 is still the inductance value of the first inductor L1, that is, L1.

FIG. 8 is a circuit diagram of a second mode of the multi-mode inductive circuit in FIG. 5.

As shown in FIG. 8, in still another embodiment provided in this application, when the first switch S1 is closed, and the second switch S2 and the third switch S3 are opened, the second inductor L2 independently operates as a degeneration inductor, and the first inductor L1 does not operate. Therefore, the inductance value of the multi-mode inductive circuit 222 is an inductance value of the second inductor L2, that is, L2. For example, when a coupling relationship exists between the first inductor L1 and the second inductor L2, the inductance value of the multi-mode inductive circuit 222 is still the inductance value of the second inductor L2, that is, L2.

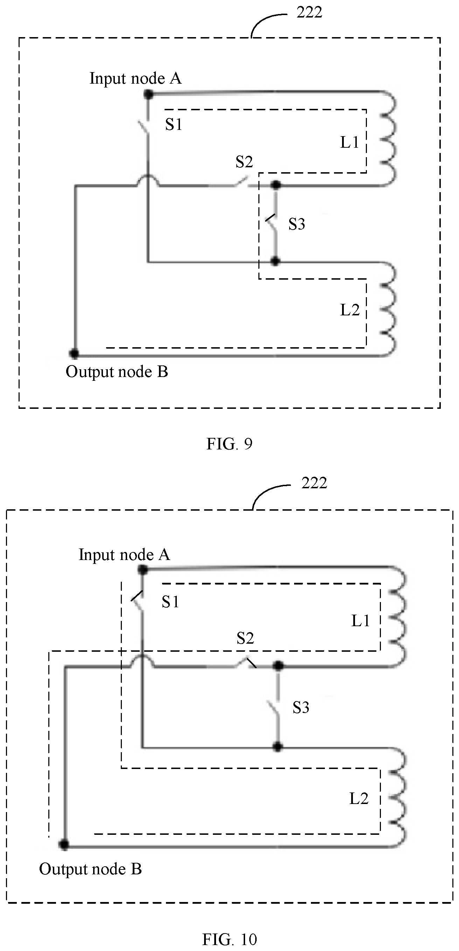

FIG. 9 is a circuit diagram of a third mode of the multi-mode inductive circuit in FIG. 5.

As shown in FIG. 9, in another embodiment provided in this application, when the third switch S3 is closed, and the first switch S1 and the second switch S2 are opened, the first inductor L1 and the second inductor L2 are connected in series to operate as a degeneration inductor. Therefore, the inductance value of the multi-mode inductive circuit 222 is a series inductance value of the first inductor L1 and the second inductor L2, that is, L1+L2.

FIG. 10 is a circuit diagram of a fourth mode of the multi-mode inductive circuit in FIG. 5.

As shown in FIG. 10, in another embodiment provided in this application, when the first switch S1 and the second switch S2 are closed, and the third switch S3 is opened, the first inductor L1 and the second inductor L2 are connected in parallel to operate as a degeneration inductor. Therefore, the inductance value of the multi-mode inductive circuit 222 is a parallel inductance value of the first inductor L1 and the second inductor L2, that is, L1//L2. Compared with an inductance value for another mode of the multi-mode inductive circuit, the mode has a smallest inductance value and a largest quality factor, that is, a Q value, so that a higher gain can be achieved.

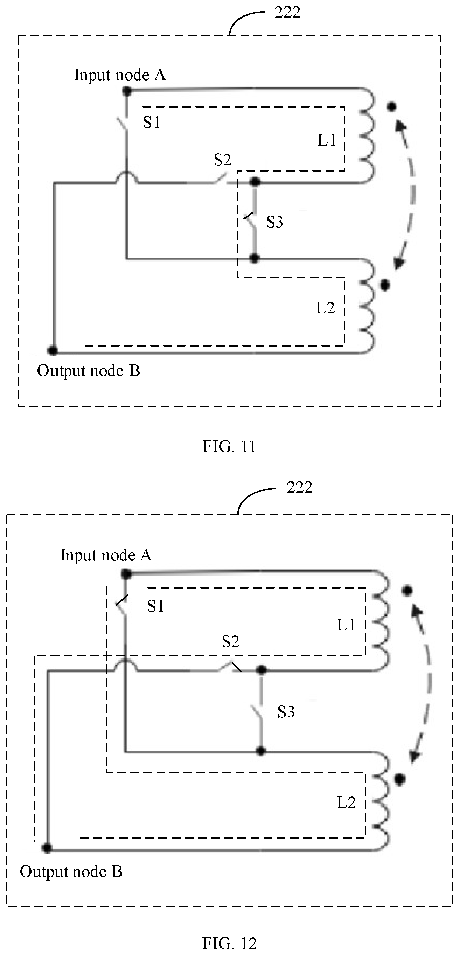

FIG. 11 is a circuit diagram of a fifth mode of the multi-mode inductive circuit in FIG. 5.

As shown in FIG. 11, in another embodiment provided in this application, when a coupling relationship exists between the first inductor L1 and the second inductor L2, the third switch S3 is closed, and the first switch S1 and the second switch S2 are opened, the first inductor L1 and the second inductor L2 are connected in series to operate as a degeneration inductor. In addition, an in-phase coupling relationship exists between the first inductor L1 and the second inductor L2. Therefore, the inductance value of the multi-mode inductive circuit 222 is a sum of a series inductance value of the first inductor L1 and the second inductor L2 and a mutual inductance value L_{M} of the first inductor L1 and the second inductor L2, that is, L1+L2+L_{M}.

FIG. 12 is a circuit diagram of a sixth mode of the multi-mode inductive circuit in FIG. 5.

As shown in FIG. 12, in another embodiment provided in this application, when a coupling relationship exists between the first inductor L1 and the second inductor L2, the first switch S1 and the second switch S2 are closed, and the third switch S3 is opened, the first inductor L1 and the second inductor L2 are connected in parallel to operate as a degeneration inductor. In addition, an in-phase coupling relationship exists between the first inductor L1 and the second inductor L2. Therefore, the inductance value of the multi-mode inductive circuit 222 is a sum of a parallel inductance value of the first inductor L1 and the second inductor L2 and a mutual inductance value L_{M} of the first inductor L1 and the second inductor L2, that is, L1//L2+L_{M}.

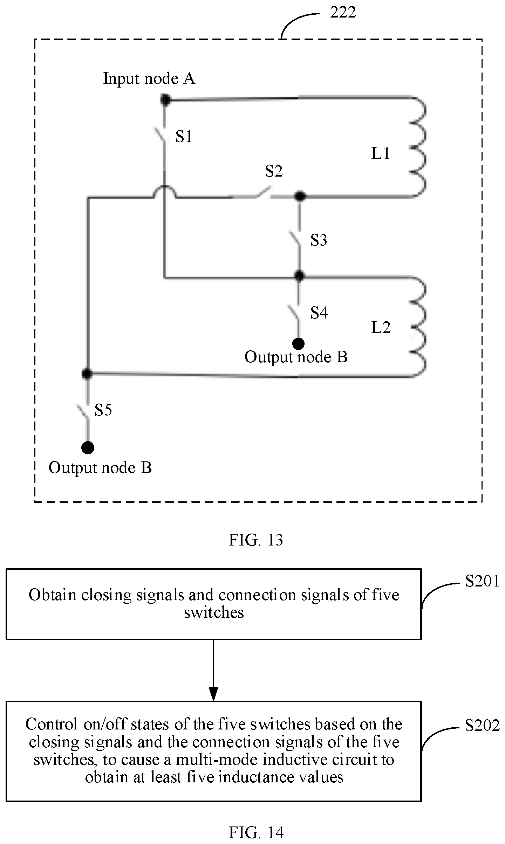

FIG. 13 is a circuit diagram of a multi-mode inductive circuit according to another embodiment of this application.

As shown in FIG. 13, the multi-mode inductive circuit 222 includes a first inductor L1, a second inductor L2, a first switch S1, a second switch S2, a third switch S3, a fourth switch S4, and a fifth switch S5. An input node A is electrically connected to a first terminal of the first inductor L1. The input node A is further electrically connected to a first terminal of the second inductor L2 through the first switch S1. A second terminal of the first inductor L1 is electrically connected to an output node B through the second switch S2. The second terminal of the first inductor L1 is further electrically connected to the first terminal of the second inductor L2 through the third switch S3. The second terminal of the second inductor L2 is electrically connected to the output node B. The first terminal of the second inductor L2 is further electrically connected to the output node B through the fourth switch S4. The second terminal of the second inductor L2 is further electrically connected to the output node B through the fifth switch S5. In addition, the input node A is further electrically connected to a source of a common-source amplifier. At least five inductance values of the multi-mode inductive circuit 222 are determined through closing and opening of the first switch S1, the second switch S2, the third switch S3, the fourth switch S4, and the fifth switch S5.

In this embodiment of this application, the multi-mode inductive circuit may be obtained through two inductors, that is, the first inductor L1 and the second inductor L2, and five switches, that is, the first switch S1, the second switch S2, the third switch S3, the fourth switch S4, and the fifth switch S5. An inductor having at least five inductance values is obtained through closing and opening of the five switches, so that a low noise amplifier can obtain at least five gain modes. In an actual application process, switching among at least five gain modes may be implemented based on an actual situation.

FIG. 14 is a circuit diagram of a multi-mode inductive circuit according to another embodiment of this application.

As shown in FIG. 14, this embodiment of this application further discloses a control method for a multi-mode inductive circuit, including the following steps.

S201: Obtain closing signals and connection signals of five switches, that is, obtain closing signals and connection signals of a first switch S1, a second switch S2, a third switch S3, a fourth switch S4, and a fifth switch S5 manually or externally.

S302: Control on/off states of the five switches based on the closing signals and the connection signals of the five switches, to cause the multi-mode inductive circuit to obtain at least five inductance values. In other words, on/off states of the first switch S1, the second switch S2, the third switch S3, the fourth switch S4, and the fifth switch S5 are controlled based on the closing signals and the connection signals of the first switch S1, the second switch S2, the third switch S3, the fourth switch S4, and the fifth switch S5, so that the multi-mode inductive circuit 222 forms different inductance paths and obtains different inductance values, thereby causing the low noise amplifier to obtain more gain modes.

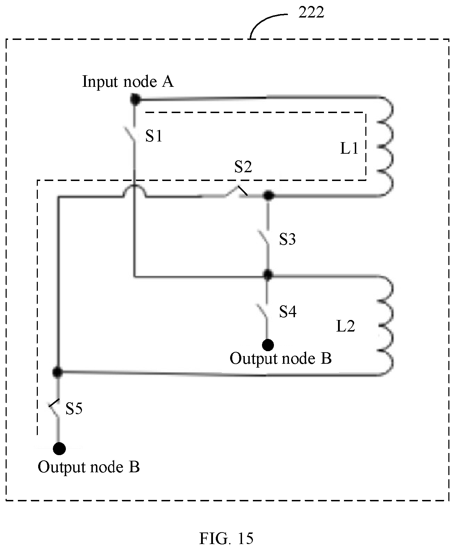

FIG. 15 is a circuit diagram of a first mode of the multi-mode inductive circuit in FIG. 13.

As shown in FIG. 15, in another embodiment provided in this application, when a second switch S2 and a fifth switch S5 are closed, and a first switch S1, a third switch S3, and a fourth switch S4 are opened, a first inductor L1 independently operates as a degeneration inductor, and a second inductor L2 does not operate. Therefore, an inductance value of a multi-mode inductive circuit 222 is an inductance value of the first inductor L1, that is, L1. For example, when a coupling relationship exists between the first inductor L1 and the second inductor L2, the inductance value of the multi-mode inductive circuit 222 is still the inductance value of the first inductor L1, that is, L1.

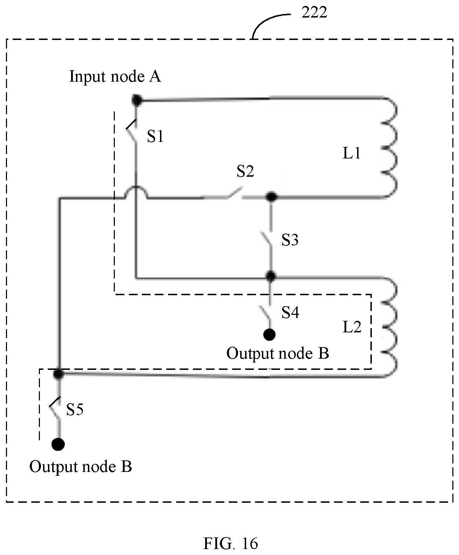

FIG. 16 is a circuit diagram of a second mode of the multi-mode inductive circuit in FIG. 13.

As shown in FIG. 16, in another embodiment provided in this application, when a first switch S1 and a fifth switch S5 are closed, and a second switch S2, a third switch S3, and a fourth switch S4 are opened, a second inductor L2 independently operates as a degeneration inductor, and the first inductor L1 does not operate. Therefore, an inductance value of a multi-mode inductive circuit 222 is an inductance value of the second inductor L2, that is, L2. For example, when a coupling relationship exists between the first inductor L1 and the second inductor L2, the inductance value of the multi-mode inductive circuit 222 is still the inductance value of the second inductor L2, that is, L2.

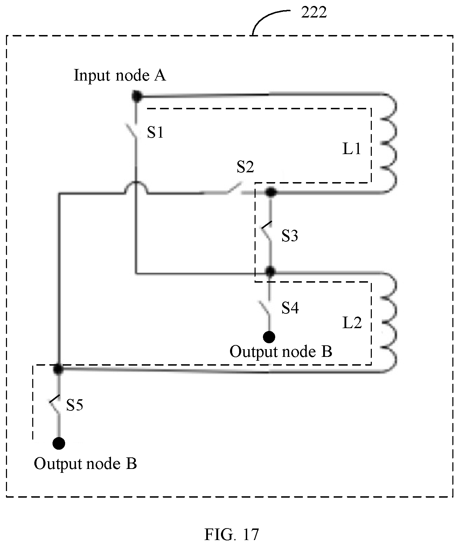

FIG. 17 is a circuit diagram of a third mode of the multi-mode inductive circuit in FIG. 13.

As shown in FIG. 17, in another embodiment provided in this application, when a third switch S3 and a fifth switch S5 are closed, and a first switch S1, a second switch S2, and a fourth switch S4 are opened, a first inductor L1 and a second inductor L2 are connected in series to operate as a degeneration inductor. Therefore, an inductance value of the multi-mode inductive circuit 222 is a series inductance value of the first inductor L1 and the second inductor L2, that is, L1+L2.

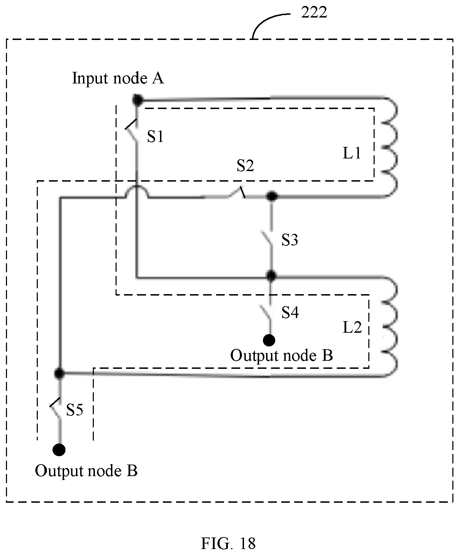

FIG. 18 is a circuit diagram of a fourth mode of the multi-mode inductive circuit in FIG. 13.

As shown in FIG. 18, in another embodiment provided in this application, when a first switch S1, a second switch S2, and a fifth switch S5 are closed, and a third switch S3 and a fourth switch S4 are opened, a first inductor L1 and a second inductor L2 are connected in parallel to operate as a degeneration inductor. Therefore, an inductance value of a multi-mode inductive circuit 222 is a parallel inductance value of the first inductor L1 and the second inductor L2, that is, L1//L2.

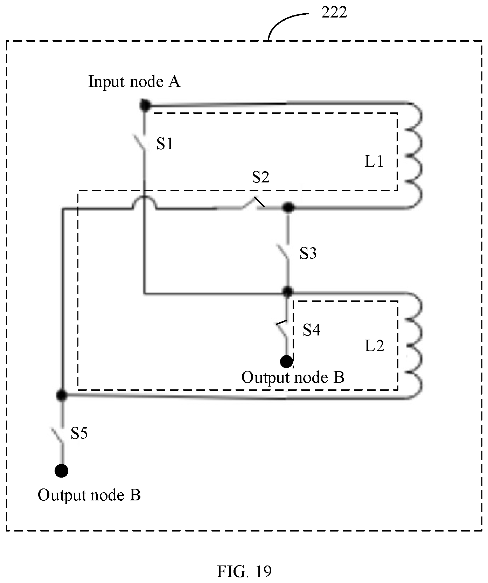

FIG. 19 is a circuit diagram of a fifth mode of the multi-mode inductive circuit in FIG. 13.

As shown in FIG. 19, in still another embodiment provided in this application, when a second switch S2 and a fourth switch S4 are closed, and a first switch S1, a third switch S3, and a fifth switch S5 are opened, a first inductor L1 and a second inductor L2 are connected in series to operate as a degeneration inductor. Therefore, an inductance value of a multi-mode inductive circuit 222 is a series inductance value of the first inductor L1 and the second inductor L2, that is, L1+L2.

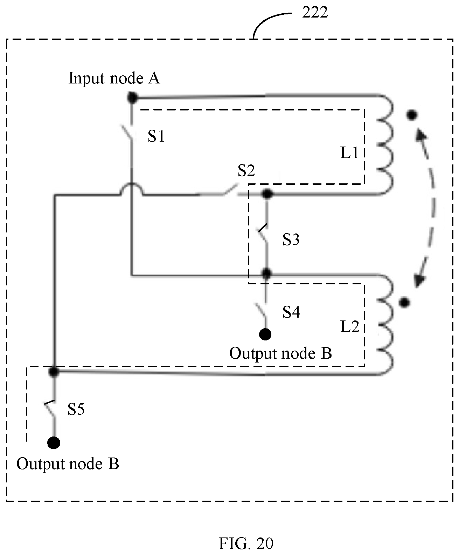

FIG. 20 is a circuit diagram of a sixth mode of the multi-mode inductive circuit in FIG. 13.

As shown in FIG. 20, in another embodiment provided in this application, when a coupling relationship exists between a first inductor L1 and a second inductor L2, a third switch S3 and a fifth switch S5 are closed, and a first switch S1, a second switch S2, and a fourth switch S4 are opened, the first inductor L1 and the second inductor L2 are subjected to in-phase in-series connection to operate as a degeneration inductor. In addition, an in-phase coupling relationship exists between the first inductor L1 and the second inductor L2. Therefore, an inductance value of a multi-mode inductive circuit 222 is a sum of a series inductance value of the first inductor L1 and the second inductor L2 and a mutual inductance value L_{M} of the first inductor L1 and the second inductor L2, that is, L1+L2+L_{M}.

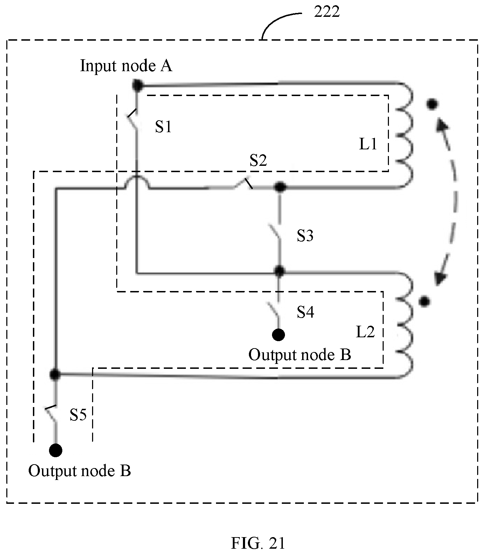

FIG. 21 is a circuit diagram of a seventh mode of the multi-mode inductive circuit in FIG. 13.

As shown in FIG. 21, in another embodiment provided in this application, when a coupling relationship exists between a first inductor L1 and a second inductor L2, a first switch S1, a second switch S2, and a fifth switch S5 are closed, and a third switch S3 and a fourth switch S4 are opened, the first inductor L1 and the second inductor L2 are subjected to in-phase in-series connection to operate as a degeneration inductor. In addition, an in-phase coupling relationship exists between the first inductor L1 and the second inductor L2. Therefore, an inductance value of a multi-mode inductive circuit 222 is a sum of a parallel inductance value of the first inductor L1 and the second inductor L2 and a mutual inductance value L_{M} of the first inductor L1 and the second inductor L2, that is, L1//L2+L_{M}. Compared with an inductance value for another mode of the multi-mode inductive circuit, the mode has a smallest inductance value and a largest quality factor, that is, a Q value, so that a higher gain can be achieved.

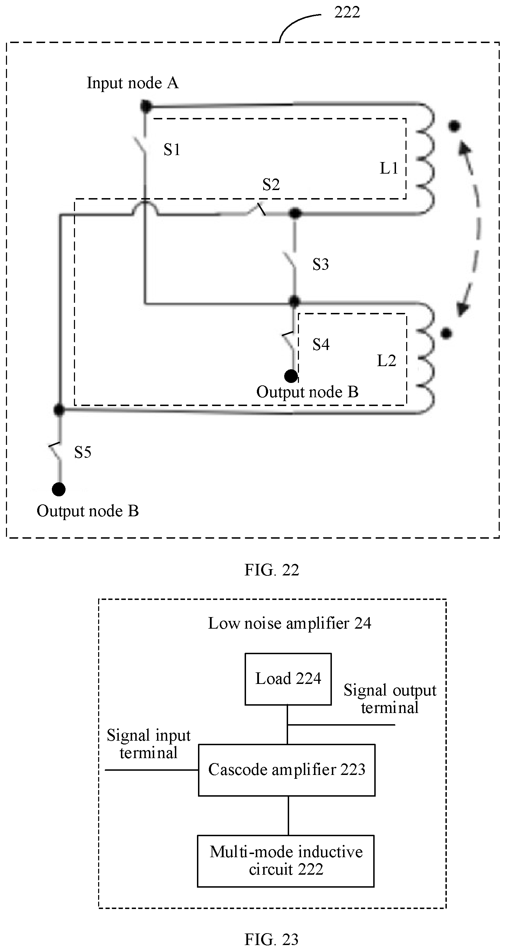

FIG. 22 is a circuit diagram of an eighth mode of the multi-mode inductive circuit in FIG. 13.

As shown in FIG. 22, in another embodiment provided in this application, when a coupling relationship exists between a first inductor L1 and a second inductor L2, a second switch S2 and a fourth switch S4 are closed, and a first switch S1, a third switch S3, and a fifth switch S5 are opened, the first inductor L1 and the second inductor L2 are subjected to reversed-phase in-series connection to operate as a degeneration inductor. In addition, a reversed-phase coupling relationship exists between the first inductor L1 and the second inductor L2. Therefore, an inductance value of a multi-mode inductive circuit 222 is a sum of a series inductance value of the first inductor L1 and the second inductor L2 and a negative mutual inductance value L_{M} of the first inductor L1 and the second inductor L2, that is, L1+L2-L_{M}.

With reference to FIG. 23 to FIG. 33, a scheme in which a low noise amplifier having at least four inductance values is obtained through at least two inductors and at least three switches is described below.

FIG. 23 is a schematic structural diagram of a low noise amplifier according to an embodiment of this application.

As shown in FIG. 23, in an embodiment provided in this application, a low noise amplifier 24 includes a multi-mode inductive circuit 222, a cascode amplifier 223, and a load 224. The cascode amplifier 223 is respectively electrically connected to the multi-mode inductive circuit 222 and the load 224. In addition, the cascode amplifier 223 is further respectively electrically connected to a signal input terminal and a signal output terminal.

In this embodiment of this application, the cascode amplifier 223 is configured to amplify an input signal. The load 224 is configured to perform frequency selection on an output signal. The multi-mode inductive circuit 222 obtains inductance values of at least four modes, so that the low noise amplifier obtains at least four gain modes.

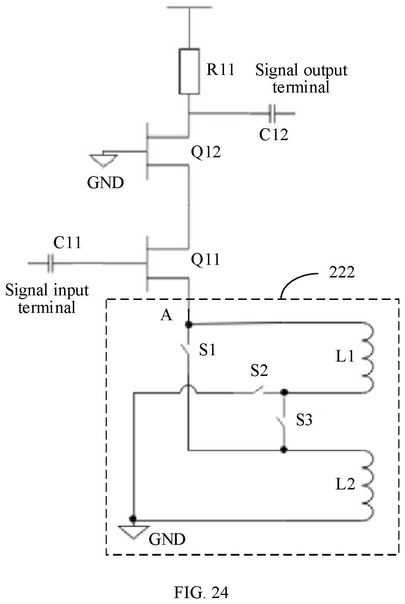

FIG. 24 is a circuit diagram of a low noise amplifier according to an embodiment of this application.

As shown in FIG. 24, in an embodiment provided in this application, the low noise amplifier may include the multi-mode inductive circuit 222 shown in FIG. 5, a power supply, an eleventh resistor R11, and a cascode amplifier obtained by cascading a common-source amplifier Q11 and a common-gate amplifier Q12. A gate of the common-source amplifier Q11 is electrically connected to a signal input terminal. A source of the common-source amplifier Q11 is electrically connected to an input node A of the multi-mode inductive circuit 222. A drain of the common-source amplifier Q11 is electrically connected to a source of the common-gate amplifier Q12. A gate of the common-gate amplifier Q12 is grounded. A drain of the common-gate amplifier Q12 is electrically connected to the power supply through the eleventh resistor R11. The drain of the common-gate amplifier Q12 is further electrically connected to a signal output terminal. For example, the low noise amplifier further includes an eleventh capacitor C11 and a twelfth capacitor C12. The eleventh capacitor C11 is connected in series between the signal input terminal and the common-source amplifier Q11. The twelfth capacitor C12 is connected in series between the signal output terminal and the common-gate amplifier Q12.

In this embodiment of this application, the common-source amplifier Q11 and the common-gate amplifier Q12 jointly form the cascode amplifier, which is configured to amplify an input signal. The eleventh resistor R11 is configured to perform a frequency selection on an output signal. The eleventh capacitor C11 is configured to filter an input signal. The twelfth capacitor C12 is configured to filter an output signal. The multi-mode inductive circuit 222 may obtain the inductance values of the six modes shown in FIG. 7 to FIG. 12, so that the low noise amplifier can obtain six gain modes.

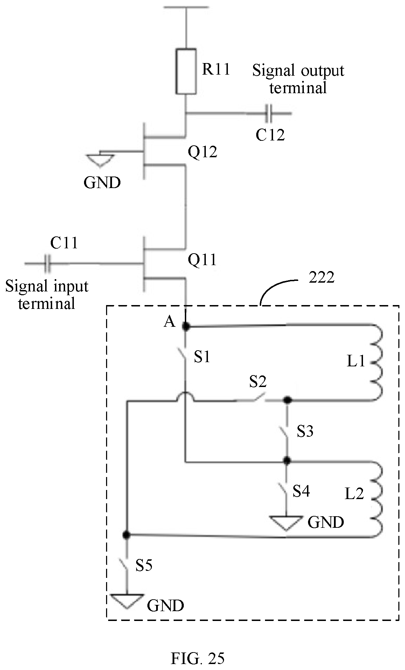

FIG. 25 is circuit diagram of a low noise amplifier according to another embodiment of this application.

As shown in FIG. 25, in an embodiment provided in this application, the low noise amplifier may include the multi-mode inductive circuit 222 shown in FIG. 13, a power supply, an eleventh resistor R11, and a cascode amplifier obtained by cascading a common-source amplifier Q11 and a common-gate amplifier Q12. A gate of the common-source amplifier Q11 is electrically connected to a signal input terminal. A source of the common-source amplifier Q11 is electrically connected to an input node A of the multi-mode inductive circuit 222. A drain of the common-source amplifier Q11 is electrically connected to a source of the common-gate amplifier Q12. A gate of the common-gate amplifier Q12 is grounded. A drain of the common-gate amplifier Q12 is electrically connected to the power supply through the eleventh resistor R11. The drain of the common-gate amplifier Q12 is further electrically connected to a signal output terminal. For example, the low noise amplifier further includes an eleventh capacitor C11 and a twelfth capacitor C12. The eleventh capacitor C11 is connected in series between the signal input terminal and the common-source amplifier Q11. The twelfth capacitor C12 is connected in series between the signal output terminal and the common-gate amplifier Q12.

In this embodiment of this application, the common-source amplifier Q11 and the common-gate amplifier Q12 jointly form the cascode amplifier, which is configured to amplify an input signal. The eleventh resistor R11 is configured to perform a frequency selection on an output signal. The eleventh capacitor C11 is configured to filter an input signal. The twelfth capacitor C12 is configured to filter an output signal. The multi-mode inductive circuit 222 may obtain the inductance values of the six modes shown in FIG. 15 to FIG. 22, so that the low noise amplifier can obtain eight gain modes.

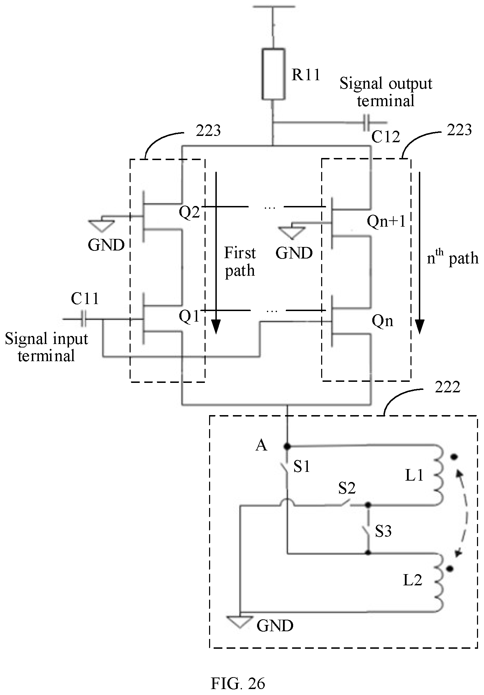

FIG. 26 is circuit diagram of a low noise amplifier according to another embodiment of this application.

As shown in FIG. 26, in an embodiment provided in this application, the low noise amplifier may include 1 to n cascode amplifiers 223, an eleventh resistor R11, and the multi-mode inductive circuit 222 shown in FIG. 5. The 1 to n cascode amplifiers 223 are all connected in parallel to the multi-mode inductive circuit 222 and the eleventh resistor R11. Current directions of the 1 to n cascode amplifiers are respectively shown as a first path to an n^{th} path.

For example, the first cascode amplifier may include a first common-source amplifier Q1 and a second common-gate amplifier Q2 that are cascaded. The n^{th} cascode amplifier may include an n^{th} common-source amplifier Qn and an (n+1)^{th} common-gate amplifier Qn+1 that are cascaded. A gate of the first common-source amplifier Q1 to a gate of the n^{th} common-source amplifier on are all electrically connected to a signal input terminal. A source of the first common-source amplifier Q1 to a source of the n^{th} common-source amplifier Qn are all electrically connected to an input terminal of the multi-mode inductive circuit 222. A drain of the first common-source amplifier Q1 to a drain of the n^{th} common-source amplifier Qn are respectively electrically connected to a source of the second common-gate amplifier Q2 to a source of the (n+1)^{th} common-gate amplifier Qn+1. A gate of the second common-gate amplifier Q2 to a gate of the (n+1)^{th} common-gate amplifier Qn+1 are all grounded. A drain of the second common-gate amplifier Q2 to a drain of the (n+1)^{th} common-gate amplifier Qn+1 are all electrically connected to a signal output terminal. The 1 to n cascode amplifiers 223 may independently operate with the multi-mode inductive circuit 222, or may operate with the multi-mode inductive circuit 222 after being combined in any manner.

Optionally, one or more first common-source amplifiers Q1 and one or more n^{th} common-source amplifiers Qn may be provided. One or more common-gate amplifiers Q2 and one or more (n+1)^{th} common-gate amplifiers Qn+1 may be provided. In other words, according to a requirement of an actual situation, each cascode amplifier 223 may also be formed by one or more common-source amplifiers and common-gate amplifiers.

In this embodiment of this application, a magnitude of a current of the low noise amplifier may be adjusted through the 1 to n cascode amplifiers 223. A larger quantity of the cascode amplifiers 223 indicates a larger current value. This also affects a gain of the low noise amplifier. Therefore, the cascode amplifier 223 including a plurality of current values is combined with the multi-mode inductive circuit 222 including six inductance value modes shown in FIG. 7 to FIG. 12 in embodiments of this application, so that the low noise amplifier can obtain more gain modes.

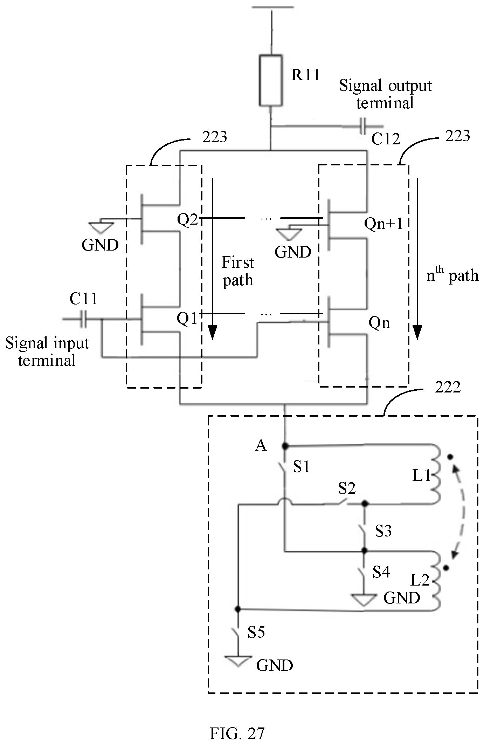

FIG. 27 is circuit diagram of a low noise amplifier according to another embodiment of this application.

As shown in FIG. 27, in an embodiment provided in this application, the low noise amplifier may include 1 to n cascode amplifiers 223, an eleventh resistor R11, and the multi-mode inductive circuit 222 shown in FIG. 13. The 1 to n cascode amplifiers 223 are all connected in parallel to the multi-mode inductive circuit 222 and the eleventh resistor R11. Current directions of the 1 to n cascode amplifiers are respectively shown as a first path to an n^{th} path.

For example, the first cascode amplifier may include a first common-source amplifier Q1 and a second common-gate amplifier Q2 that are cascaded. The n^{th} cascode amplifier may include an n^{th} common-source amplifier Qn and an (n+1)^{th} common-gate amplifier Qn+1 that are cascaded. A gate of the first common-source amplifier Q1 to a gate of the n^{th} common-source amplifier on are all electrically connected to a signal input terminal. A source of the first common-source amplifier Q1 to a source of the n^{th} common-source amplifier Qn are all electrically connected to an input terminal of the multi-mode inductive circuit 222. A drain of the first common-source amplifier Q1 to a drain of the n^{th} common-source amplifier Qn are respectively electrically connected to a source of the second common-gate amplifier Q2 to a source of the (n+1)^{th} common-gate amplifier Qn+1. A gate of the second common-gate amplifier Q2 to a gate of the (n+1)^{th} common-gate amplifier Qn+1 are all grounded. A drain of the second common-gate amplifier Q2 to a drain of the (n+1)^{th} common-gate amplifier Qn+1 are all electrically connected to a signal output terminal. The 1 to n cascode amplifiers 223 may independently operate with the multi-mode inductive circuit 222, or may operate with the multi-mode inductive circuit 222 after being combined in any manner.

Optionally, one or more first common-source amplifiers Q1 and one or more n^{th} common-source amplifiers Qn may be provided. One or more common-gate amplifiers Q2 and one or more (n+1)^{th} common-gate amplifiers Qn+1 may be provided. In other words, according to a requirement of an actual situation, each cascode amplifier 223 may also be formed by one or more common-source amplifiers and common-gate amplifiers.

In this embodiment of this application, a magnitude of a current of the low noise amplifier may be adjusted through the 1 to n cascode amplifiers 223. A larger quantity of the cascode amplifiers 223 indicates a larger current value. This also affects a gain of the low noise amplifier. Therefore, the cascode amplifier 223 including a plurality of current values is combined with the multi-mode inductive circuit 222 including eight inductance value modes shown in FIG. 15 to FIG. 22 in embodiments of this application, so that the low noise amplifier can obtain more gain modes.

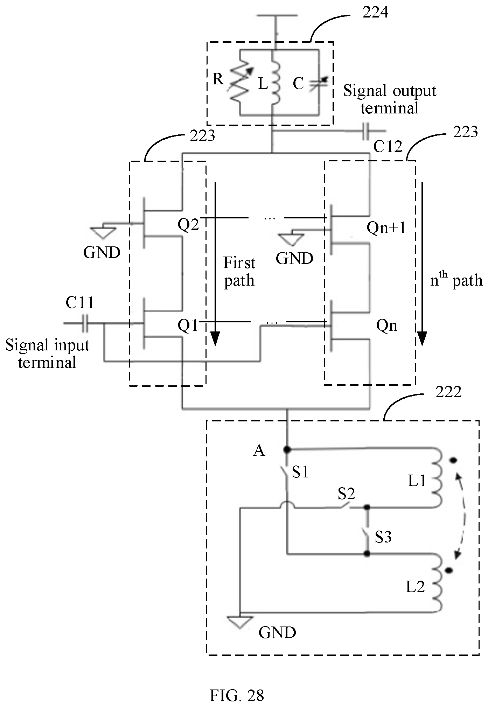

FIG. 28 is circuit diagram of a low noise amplifier according to another embodiment of this application.

As shown in FIG. 28, in an embodiment provided in this application, the low noise amplifier may include a load 224 including an adjustable resistor R, an inductor L, and an adjustable capacitor C, 1 to n cascode amplifiers 223, and the multi-mode inductive circuit 222 shown in FIG. 5. For example, one terminal of the adjustable resistor R, one terminal of the inductor L, and one terminal of the adjustable capacitor C are all electrically connected to a power supply. An other terminal of the adjustable resistor R, an other terminal of the inductor L, and an other terminal of the adjustable capacitor C are all electrically connected to a signal output terminal.

In this embodiment of this application, the inductor L and the adjustable capacitor C form an LC frequency selection network. In combination with the adjustable resistor R, a plurality of different frequency selection ranges may be obtained, to perform a frequency selection on an output signal of the low noise amplifier. Therefore, the load 224 including a plurality of frequency selection ranges is combined with the multi-mode inductive circuit 222 including six inductance value modes shown in FIG. 7 to FIG. 12 in this embodiment of this application, so that the low noise amplifier can obtain more gain modes.

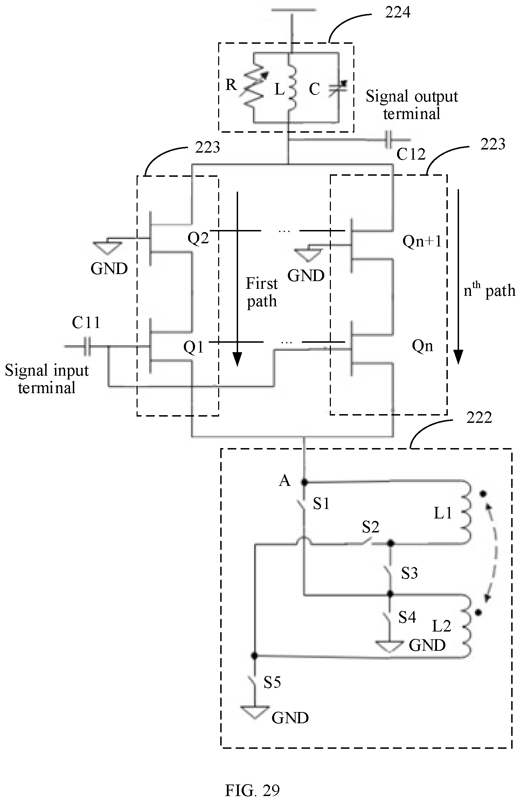

FIG. 29 is circuit diagram of a low noise amplifier according to another embodiment of this application.

As shown in FIG. 29, in an embodiment provided in this application, the low noise amplifier may include a load 224 including an adjustable resistor R, an inductor L, and an adjustable capacitor C, 1 to n cascode amplifiers 223, and the multi-mode inductive circuit 222 shown in FIG. 13. For example, one terminal of the adjustable resistor R, one terminal of the inductor L, and one terminal of the adjustable capacitor C are all electrically connected to a power supply. An other terminal of the adjustable resistor R, an other terminal of the inductor L, and an other terminal of the adjustable capacitor C are all electrically connected to a signal output terminal.

In this embodiment of this application, the inductor L and the adjustable capacitor C form an LC frequency selection network. In combination with the adjustable resistor R, a plurality of different frequency selection ranges may be obtained, to perform a frequency selection on an output signal of the low noise amplifier. Therefore, the load 224 including a plurality of frequency selection ranges is combined with the multi-mode inductive circuit 222 including eight inductance value modes shown in FIG. 15 to FIG. 22 in this embodiment of this application, so that the low noise amplifier can obtain more gain modes.

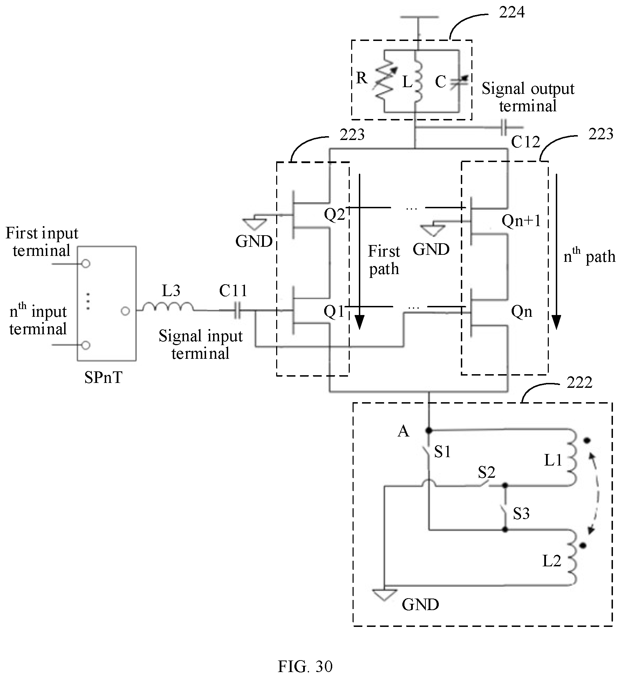

FIG. 30 is circuit diagram of a low noise amplifier according to another embodiment of this application.

As shown in FIG. 30, in an embodiment provided in this application, the low noise amplifier may include an input switch SPnT and a matching inductor L3, 1 to n cascode amplifiers 223, a load 224, and the multi-mode inductive circuit 222 shown in FIG. 5. For example, a movable terminal of the input switch SPnT receives input signals of a plurality of bands, and a fixed terminal of the input switch SPnT is electrically connected to a signal input terminal through the matching inductor L3. Optionally, the input switch SPnT may include 1 to n input terminals and one output terminal.

In this embodiment of this application, multi-band switching of an input signal is implemented through the 1 to n input terminals of the input switch SPnT. In other words, when one of a first input terminal to an n^{th} input terminal of the input switch SPnT is conducted with the output terminal, a band selection for the input terminal is implemented. The low noise amplifier selectively receives an input signal of the band. Through the matching inductor L3, noise matching or gain impedance matching of a multi-band input signal may be implemented. The input switch SPnT and the matching inductor L3 are combined with the multi-mode inductive circuit 222 including six inductance value modes shown in FIG. 7 to FIG. 12 in this embodiment of this application, so that the low noise amplifier can obtain more gain modes.

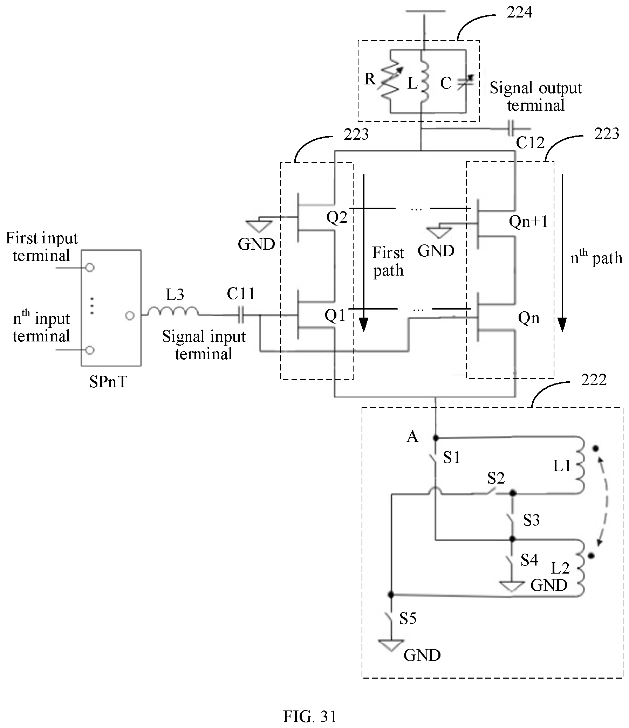

FIG. 31 is circuit diagram of a low noise amplifier according to another embodiment of this application.

As shown in FIG. 31, in an embodiment provided in this application, the low noise amplifier may include an input switch SPnT and a matching inductor L3, 1 to n cascode amplifiers 223, a load 224, and the multi-mode inductive circuit 222 shown in FIG. 13. For example, a movable terminal of the input switch SPnT receives input signals of a plurality of bands, and a fixed terminal of the input switch SPnT is electrically connected to a signal input terminal through the matching inductor L3. Optionally, the input switch SPnT may include 1 to n input terminals and one output terminal.

In this embodiment of this application, multi-band switching of an input signal is implemented through the 1 to n input terminals of the input switch SPnT. In other words, when one of a first input terminal to an n^{th} input terminal of the input switch SPnT is conducted with the output terminal, a band selection for the input terminal is implemented. The low noise amplifier selectively receives an input signal of the band. Through the matching inductor L3, noise matching or gain impedance matching of a multi-band input signal may be implemented. The input switch SPnT and the matching inductor L3 are combined with the multi-mode inductive circuit 222 including eight inductance value modes shown in FIG. 15 to FIG. 22 in this embodiment of this application, so that the low noise amplifier can obtain more gain modes.

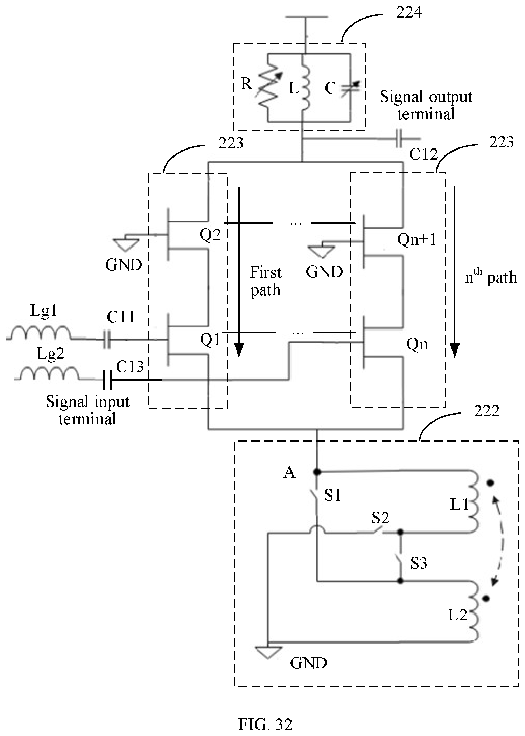

FIG. 32 is circuit diagram of a low noise amplifier according to another embodiment of this application.

As shown in FIG. 32, in an embodiment provided in this application, the low noise amplifier may include a first input inductor Lg1 to an n^{th} input inductor Lgn, 1 to n cascode amplifiers 223, a load 224, and the multi-mode inductive circuit 222 shown in FIG. 5. The first input inductor Lg1 to the n^{th} input inductor Lgn are respectively electrically connected to a gate of the first common-source amplifier Q1 to a gate of the n^{th} common-source amplifier Qn.

In this embodiment of this application, noise matching or gain impedance matching of specific bands of an input signal may be implemented through the first input inductor Lg1 to the n^{th} input inductor Lgn. The first input inductor Lg1 to the n^{th} input inductor Lgn for a plurality of input bands are combined with the multi-mode inductive circuit 222 including six inductance value modes shown in FIG. 7 to FIG. 12 in embodiments of this application, so that the low noise amplifier can obtain more gain modes.

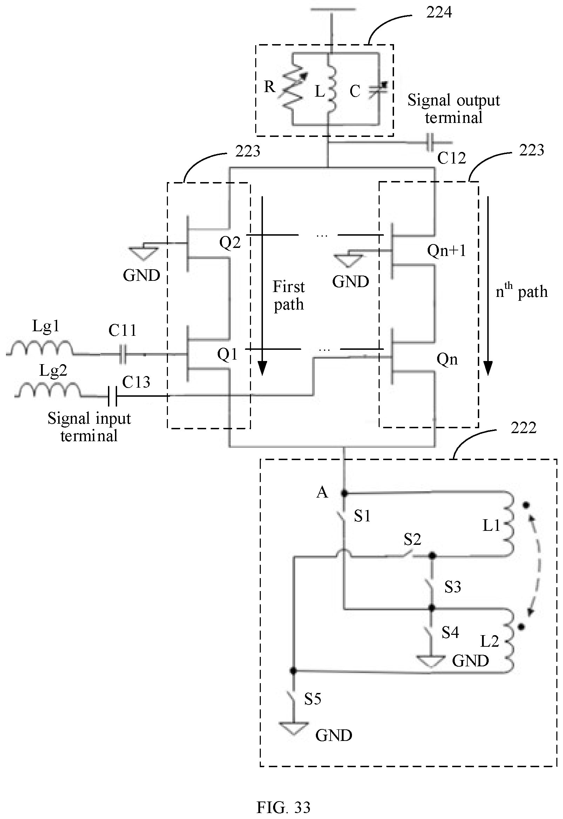

FIG. 33 is circuit diagram of a low noise amplifier according to another embodiment of this application.

As shown in FIG. 33, in an embodiment provided in this application, the low noise amplifier may include a first input inductor Lg1 to an n^{th} input inductor Lgn, 1 to n cascode amplifiers 223, a load 224, and the multi-mode inductive circuit 222 shown in FIG. 13. The first input inductor Lg1 to the n^{th} input inductor Lgn are respectively electrically connected to a gate of the first common-source amplifier Q1 to a gate of the n^{th} common-source amplifier Qn.

In this embodiment of this application, noise matching or gain impedance matching of specific bands of an input signal may be implemented through the first input inductor Lg1 to the n^{th} input inductor Lgn. The first input inductor Lg1 to the n^{th} input inductor Lgn for a plurality of input bands are combined with the multi-mode inductive circuit 222 including six inductance value modes shown in FIG. 15 to FIG. 22 in embodiments of this application, so that the low noise amplifier can obtain more gain modes.

An embodiment of this application further provides an electronic device, including the foregoing plurality of low noise amplifiers. The low noise amplifier includes the foregoing multi-mode inductive circuit 222. Through the plurality of low noise amplifiers of the foregoing multi-mode circuit 222 having a plurality of inductance values, switching among a plurality of gain modes can be performed, to satisfy requirements of switching among a plurality of band modes and switching among a plurality of gain modes for the terminal transceiver.

It should be understood that the foregoing is merely an example for a structure of the electronic device 100, and the electronic device 100 may alternatively include another subsystem or device, which may be specifically arranged and modified based on a requirement. This is not limited in this embodiment of this application.

For the beneficial effects that can be achieved by the electronic device provided in embodiments of this application, reference may be made to the beneficial effects corresponding to the module provided above. Details are not described herein again.

It should be understood that the foregoing descriptions are intended to help a person skilled in the art to better understand embodiments of this application, but not to limit the scope of embodiments of this application. A person skilled in the art obviously may make various equivalent modifications or changes based on the given examples. For example, some steps in various embodiments of a detection method may be unnecessary, or some steps may be newly added. Or any two or more above embodiments may be combined. Solutions of such modifications, changes, or combination also fall within the scope of embodiments of this application. In addition, the displayed or discussed mutual coupling or direct coupling or communication connection may be implemented through some interfaces. The indirect coupling or communication connection between the apparatuses or units may be implemented in an electronic, mechanical, or another form.

The units described as separate components may or may not be physically separated, and the components displayed as units may or may not be physical units, and may be located in one place or may be distributed over a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

It should be further understood that the foregoing descriptions of embodiments of this application emphasize differences between embodiments. For the same or similar descriptions not mentioned, reference may be made to each other. For brevity, details are not described herein again.

It should be further understood that sequence numbers of the processes do not mean execution sequences in various embodiments of this application. The execution sequences of the processes should be determined based on functions and internal logic of the processes should not constitute any limitation on the implementation processes of embodiments of this application.

It should be further understood that, in embodiments of this application, "presetting" or "predefining" may be implemented by storing corresponding code, a table, or other related information that may be used for indication in a device (for example, including an electronic device) in advance. A specific implementation of "presetting" or "predefining" is not limited in this application.

It should be further understood that division of manners, situations, categories, and embodiments in the embodiment of this application merely aims to facilitate description rather than constitute specific limitations, and characteristics in various manners, categories, situations, and embodiments may be combined without contradictions.

It should be further understood that, in embodiments of this application, unless otherwise stated or there is a logic conflict, terms and/or descriptions between different embodiments are consistent and may be mutually referenced, and technical features in different embodiments may be combined into a new embodiment based on an internal logical relationship thereof.

Finally, it should be noted that the foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims. In conclusion, the foregoing embodiments are merely preferred embodiments of the technical solutions of this application, and are not used for limiting the protection scope of this application. Any modification, equivalent replacement, or improvement made without departing from the spirit and principle of this application shall fall within the protection scope of this application.

## Claims

1. A multi-mode inductive circuit, comprising an input node, a first inductor, a second inductor, a first switch, a second switch, a third switch, and an output node, wherein
the input node is electrically connected to a first terminal of the first inductor, the input node is further electrically connected to a first terminal of the second inductor through the first switch, a second terminal of the first inductor is electrically connected to the output node through the second switch, the second terminal of the first inductor is further electrically connected to the first terminal of the second inductor through the third switch, and a second terminal of the second inductor is electrically connected to the output node; and
at least four inductance values of the multi-mode inductive circuit are determined through closing and opening of the first switch, the second switch, and the third switch.

2. The multi-mode inductive circuit according to claim 1, wherein a coupling relationship exists between the first inductor and the second inductor, and an inductance value of the first inductor and an inductance value of the second inductor interact with each other.

3. The multi-mode inductive circuit according to claim 2, further comprising a fourth switch and a fifth switch, wherein
the first terminal of the second inductor is further electrically connected to the output node through the fourth switch, and the second terminal of the second inductor is further electrically connected to the output node through the fifth switch; and
at least five inductance values of the multi-mode inductive circuit are determined through closing and opening of the first switch, the second switch, the third switch, the fourth switch, and the fifth switch.

4. A control method for the multi-mode inductive circuit according to any one of claims 1 to 3, wherein the multi-mode inductive circuit comprises an input node, a first inductor, a second inductor, a first switch, a second switch, a third switch, and an output node, and the control method for the multi-mode inductive circuit comprises:
obtaining closing signals and connection signals of three switches; and
controlling on/off states of the three switches based on the closing signals and the connection signals of the three switches, to cause the multi-mode inductive circuit to obtain at least four inductance values.

5. The control method for the multi-mode inductive circuit according to claim 4, wherein the controlling on/off states of the three switches based on the closing signals and the connection signals of the three switches, to cause the multi-mode inductive circuit to obtain at least four inductance values comprises:
one of the inductance values of the multi-mode inductive circuit is an inductance value of the first inductor when the second switch is closed and the first switch and the third switch are opened.

6. The control method for the multi-mode inductive circuit according to claim 4, wherein the controlling on/off states of the three switches based on the closing signals and the connection signals of the three switches, to cause the multi-mode inductive circuit to obtain at least four inductance values comprises:
one of the inductance values of the multi-mode inductive circuit is an inductance value of the second inductor when the first switch is closed and the second switch and the third switch are opened.

7. The control method for the multi-mode inductive circuit according to claim 4, wherein the controlling on/off states of the three switches based on the closing signals and the connection signals of the three switches, to cause the multi-mode inductive circuit to obtain at least four inductance values comprises:
one of the inductance values of the multi-mode inductive circuit is a series inductance value of the first inductor and the second inductor when the third switch is closed and the first switch and the second switch are opened.

8. The control method for the multi-mode inductive circuit according to claim 4, wherein the controlling on/off states of the three switches based on the closing signals and the connection signals of the three switches, to cause the multi-mode inductive circuit to obtain at least four inductance values comprises:
one of the inductance values of the multi-mode inductive circuit is a parallel inductance value of the first inductor and the second inductor when the first switch and the second switch are closed and the third switch is opened.

9. The control method for the multi-mode inductive circuit according to claim 4, wherein the controlling on/off states of the three switches based on the closing signals and the connection signals of the three switches, to cause the multi-mode inductive circuit to obtain at least four inductance values comprises:
one of the inductance values of the multi-mode inductive circuit is a sum of a series inductance value of the first inductor and the second inductor and a mutual inductance value of the first inductor and the second inductor when the coupling relationship exists between the first inductor and the second inductor, the third switch is closed, and the first switch and the second switch are opened.

10. The control method for the multi-mode inductive circuit according to claim 4, wherein the controlling on/off states of the three switches based on the closing signals and the connection signals of the three switches, to cause the multi-mode inductive circuit to obtain at least four inductance values comprises:
one of the inductance values of the multi-mode inductive circuit is a sum of a parallel inductance value of the first inductor and the second inductor and a mutual inductance value of the first inductor and the second inductor when the coupling relationship exists between the first inductor and the second inductor, the first switch and the second switch are closed, and the third switch is opened.

11. The control method for the multi-mode inductive circuit according to claim 4, wherein the multi-mode inductive circuit comprises the input node, the first inductor, the second inductor, the first switch, the second switch, a third switch, a fourth switch, a fifth switch, and the output node, and the control method for the multi-mode inductive circuit comprises:
obtaining closing signals and connection signals of five switches; and
controlling on/off states of the five switches based on the closing signals and the connection signals of the five switches, to cause the multi-mode inductive circuit to obtain at least five inductance values.

12. The control method for the multi-mode inductive circuit according to claim 11, wherein the controlling on/off states of the five switches based on the closing signals and the connection signals of the five switches, to cause the multi-mode inductive circuit to obtain at least five inductance values comprises:
one of the inductance values of the multi-mode inductive circuit is the inductance value of the first inductor when the second switch and the fifth switch are closed and the first switch, the third switch, and the fourth switch are opened.

13. The control method for the multi-mode inductive circuit according to claim 11, wherein the controlling on/off states of the five switches based on the closing signals and the connection signals of the five switches, to cause the multi-mode inductive circuit to obtain at least five inductance values comprises:
one of the inductance values of the multi-mode inductive circuit is the inductance value of the second inductor when the first switch and the fifth switch are closed and the second switch, the third switch, and the fourth switch are opened.

14. The control method for the multi-mode inductive circuit according to claim 11, wherein the controlling on/off states of the five switches based on the closing signals and the connection signals of the five switches, to cause the multi-mode inductive circuit to obtain at least five inductance values comprises:
one of the inductance values of the multi-mode inductive circuit is a series inductance value of the first inductor and the second inductor when the third switch and the fifth switch are closed and the first switch, the second switch, and the fourth switch are opened.

15. The control method for the multi-mode inductive circuit according to claim 11, wherein the controlling on/off states of the five switches based on the closing signals and the connection signals of the five switches, to cause the multi-mode inductive circuit to obtain at least five inductance values comprises:
one of the inductance values of the multi-mode inductive circuit is a parallel inductance value of the first inductor and the second inductor when the first switch, the second switch, and the fifth switch are closed and the third switch and the fourth switch are opened.

16. The control method for the multi-mode inductive circuit according to claim 11, wherein the controlling on/off states of the five switches based on the closing signals and the connection signals of the five switches, to cause the multi-mode inductive circuit to obtain at least five inductance values comprises:
one of the inductance values of the multi-mode inductive circuit is a series inductance value of the first inductor and the second inductor when the second switch and the fourth switch are closed and the first switch, the third switch, and the fifth switch are opened.

17. The control method for the multi-mode inductive circuit according to claim 11, wherein the controlling on/off states of the five switches based on the closing signals and the connection signals of the five switches, to cause the multi-mode inductive circuit to obtain at least five inductance values comprises:
one of the inductance values of the multi-mode inductive circuit is a sum of a series inductance value of the first inductor and the second inductor and a mutual inductance value of the first inductor and the second inductor when the coupling relationship exists between the first inductor and the second inductor, the third switch and the fifth switch are closed, and the first switch, the second switch, and the fourth switch are opened.

18. The control method for the multi-mode inductive circuit according to claim 11, wherein the controlling on/off states of the five switches based on the closing signals and the connection signals of the five switches, to cause the multi-mode inductive circuit to obtain at least five inductance values comprises:
one of the inductance values of the multi-mode inductive circuit is a sum of a parallel inductance value of the first inductor and the second inductor and a mutual inductance value of the first inductor and the second inductor when the coupling relationship exists between the first inductor and the second inductor, the first switch, the second switch, and the fifth switch are closed, and the third switch and the fourth switch are opened.

19. The control method for the multi-mode inductive circuit according to claim 11, wherein the controlling on/off states of the five switches based on the closing signals and the connection signals of the five switches, to cause the multi-mode inductive circuit to obtain at least five inductance values comprises:
one of the inductance values of the multi-mode inductive circuit is a sum of a series inductance value of the first inductor and the second inductor and a mutual inductance value of the first inductor and the second inductor when the coupling relationship exists between the first inductor and the second inductor, the second switch and the fourth switch are closed, and the first switch, the third switch, and the fifth switch are opened.

20. A low noise amplifier, comprising the multi-mode inductive circuit according to any one of claims 1 to 3.

21. The low noise amplifier according to claim 20, further comprising a power supply and a cascode amplifier obtained by cascading a common-source amplifier and a common-gate amplifier, wherein
a gate of the common-source amplifier is electrically connected to a signal input terminal, a source of the common-source amplifier is electrically connected to an input node of the multi-mode inductive circuit, a drain of the common-source amplifier is electrically connected to a source of the common-gate amplifier, a gate of the common-gate amplifier is grounded, and a drain of the common-gate amplifier is further electrically connected to a signal output terminal and the power supply.

22. The low noise amplifier according to claim 21, comprising a plurality of cascode amplifiers, wherein gates of common-source amplifiers of the plurality of cascode amplifiers are all electrically connected to the signal input terminal, sources of the common-source amplifiers of the plurality of cascode amplifiers are all electrically connected to the input node of the multi-mode inductive circuit, and drains of common-gate amplifiers of the plurality of cascode amplifiers are all electrically connected to the signal output terminal.

23. The low noise amplifier according to claim 21 or 22, further comprising a load, wherein the load is connected between the power supply and the cascode amplifier; and
the load comprises an adjustable resistor, an inductor, and an adjustable capacitor, one terminal of the adjustable resistor, one terminal of the inductor, and one terminal of the adjustable capacitor are all electrically connected to the power supply, and an other terminal of the adjustable resistor, an other terminal of the inductor, and an other terminal of the adjustable capacitor are all electrically connected to the signal output terminal.

24. The low noise amplifier according to claim 21 or 22, further comprising an input switch and a matching inductor, wherein
a movable terminal of the input switch receives input signals of a plurality of bands, and a fixed terminal of the input switch is electrically connected to the signal input terminal through the matching inductor.

25. The low noise amplifier according to claim 21 or 22, further comprising one or more input inductors, wherein
the one or more input inductors are respectively electrically connected to the gates of one or more of the common-source amplifiers.

26. An electronic device, comprising the low noise amplifier according to any one of claims 20 to 25, wherein the low noise amplifier is configured to receive a signal.
